(19) Europäisches Patentamt
European Patent Office
Office européen des brevets

(11) **EP 3 054 601 A1**

(12) **EUROPEAN PATENT APPLICATION**

(43) Date of publication:
**10.08.2016 Bulletin 2016/32**

(51) Int Cl.:
***H03M 13/13*** (2006.01)  ***H03M 13/37*** (2006.01)
***G06F 11/10*** (2006.01)

(21) Application number: **15305185.9**

(22) Date of filing: **09.02.2015**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(71) Applicant: **Thomson Licensing**
**92130 Issy-les-Moulineaux (FR)**

(72) Inventor: **Le Scouarnec, Nicolas**
**35576 Cesson-Sévigné (FR)**

(74) Representative: **Huchet, Anne**
**Technicolor**
**1, rue Jeanne d'Arc**
**92443 Issy-les-Moulineaux Cedex (FR)**

(54) **Product-matrix regenerating codes**

(57) A class of product-matrix (PM) regenerating codes named sparse-PM regenerating codes for fault-tolerance protection in distributed storage systems is provided, designed for enhanced network bandwidth and computational performance. The codes are based on the Cauchy matrix. In particular, linear and/or systematic sparse-PM regenerating codes permit fast computations, allowing throughputs of up to about 790 MBps for typical settings. These throughputs are compatible with current practical deployments of erasure codes while presenting significant improvement in network bandwidth (network related repair cost). Methods and apparatuses for encoding, regenerating and decoding data for fault-tolerance in a distributed storage system are also provided by using sparse-PM regenerating codes.

Figure 8

**Description**

TECHNICAL FIELD

The present principles relate to fault tolerance in storage systems and in particular to product-matrix regenerating codes.

BACKGROUND

The increasing needs for storage in data centers pushed by numerous cloud-based storage services has led to the development of distributed storage systems with a better tradeoff between reliability and storage. The purpose of distributed storage systems is to store data reliably over long periods of time using a distributed collection of storage nodes, typically employing commodity components for cost considerations. These individual components are generally unreliable, and as a result, the system must deal with frequent failures of these components. In addition, various additional issues such as software glitches, machine reboots and maintenance operations also contribute to machines being rendered unavailable from time to time. Applications involve storage in large data centers and peer-to-peer storage systems which use nodes across the Internet for distributed file storage. In wireless sensor networks, obtaining reliable storage over unreliable motes might be desirable for robust data recovery, especially in catastrophic scenarios.

In all these scenarios, in order to ensure that the data remains reliable and available even in the presence of frequent machine unavailability, the introduction of redundancy is required. The simplest form of redundancy is replication, which is adopted in many practical storage systems, with data being replicated across multiple machines, typically across multiple racks as well. For instance, the Google File System and the Hadoop Distributed File System (HDFS) store three copies of all data by default. Although disk storage seems cheap for small amounts of data, the massive scales of operation of today's data-centers make storing multiple copies an expensive option. As a result, several large-scale distributed storage systems now employ erasure codes that provide significantly higher storage efficiency, with the most popular choice being the Reed-Solomon (RS) code.

As a generalization of replication, erasure correcting codes offer better storage efficiency. For instance, one can divide a file of size $B$ into $k$ pieces (to be called fragments), each of size $B/k$, encode them into n encoded fragments (of the same size) using a $(n, k)$ maximum distance separable (MDS) code (*e.g.,* Reed-Solomon codes), and store them at $n$ nodes. Then, the original file can be recovered from any set of $k$ coded fragments. This performance is optimal in terms of the redundancy-reliability tradeoff because $k$ pieces, each of size $B/k$, provide the minimum data for recovering the file, which is of size $B$. It is therefore common to use erasure codes instead of replication. For certain cases, erasure coding can achieve orders of magnitude higher reliability for the same redundancy factor compared to replication.

However, in distributed storage systems, redundancy must be continually refreshed as nodes fail or leave the system, which involves large data transfers across the network. While erasure codes allow decreasing storage costs, they generally come with higher costs in term of network, I/O (Input/Output) or CPU (Computer Processing Unit) requirements and thus, hardware cost and power consumption. With Reed-Solomon (RS) codes, B is measured in terms of symbols over a finite field $F_q$ of size $q$, and data is stored across $n$ nodes in the network in such a way that the entire message or file can be recovered by a data collector by connecting to any $k$ nodes, a process commonly referred to as *data-reconstrarction or decoding.* Several distributed storage systems such as RAID-6, OceanStore and Total Recall employ such an erasure coding technique. This implies that, in general, if an object of size $B$ is divided in $k$ initial fragments, the repair bandwidth with this strategy is $B$ to generate a fragment of size $B/k$. In contrast, if replication is used instead, a new replica may simply be copied from any other existing node, incurring no bandwidth overhead at the expense of higher storage. It was commonly believed that this $k$-factor overhead in repair bandwidth was an unavoidable disadvantage that came with the benefits of erasure coding.

In order to alleviate these various drawbacks resulting from a decreased storage, optimized codes have been designed, particularly:

- Locally repairable codes minimize I/O related costs, or access efficiency;
- XOR-based and some matrix-based erasure codes minimize CPU or computational related costs, also measured in terms of throughput; and
- Regenerating codes minimize network-related costs, that is, the amount of network access and data transfer needed. In fact, regenerating codes offer the best tradeoff between network and storage costs.

Regenerating codes were introduced by A.G. Dimakis et al. in their pioneering paper entitled "Network Coding for Distributed Storage Systems", published on IEEE Transactions on Information Theory, vol. 56, September 2010, pp. 4539-4551. The principle behind regenerating codes is that downloading the entire $B$ units of data (or $k$ nodes) in order to recover the data stored in a single node which stores only a fraction ($B/k$) of the entire message is wasteful. Conventional RS codes treat each fragment ($B/k$) stored in a node as a single symbol belonging to the finite field $F_q$. It can be shown that when individual nodes are restricted to perform only linear operations over $F_q$, the total amount of data download needed to repair a failed node, can be no smaller than $B$, the size of the entire file or message. In contrast, regenerating codes are codes over a vector alphabet and hence treat each fragment as being comprised of $\alpha$ symbols over the finite field $F_q$. Linear operations over $F_q$, in this case, permit the transfer of a fraction of the data stored at a particular node. Apart from this new parameter $\alpha$, two other parameters $d$ and $\beta$ are associated with regenerating codes. Under Dimakis' definition of regenerating codes, a failed node is permitted to connect to an arbitrary set of $d$ of the remaining nodes while downloading $\alpha \leq \beta$ symbols from each node. This process is termed as *regeneration* and the total amount $d \times \beta$ of data downloaded for repair purposes is the *repair bandwidth.* Further, the set of $d$ nodes aiding in the repair are termed as helper nodes. Typically, with a regenerating code, the average repair bandwidth is small compared to the size of the file $B$.

Regenerating codes achieve the optimal tradeoff between storage and bandwidth with two main variants: MSR (Minimum Storage Regenerating) codes that favor storage, and MBR (Minimum Bandwidth Regenerating) codes that favor bandwidth. MSR codes encode $k\Delta$ blocks to $n\alpha$ blocks, wherein each device stores $\alpha$ blocks and $\alpha = \Delta = d - k + 1$. During repair, $d$ blocks are transferred over the network. MBR codes are similar but have $\alpha = d$ and $\Delta = (2d - k + 1)/2$, thus resulting in higher storage costs but lower network bandwidth during repairs.

Product-matrix regenerating codes were proposed by R.V. Rashmi et al on their seminal paper entitled "Optimal Exact-Regenerating Codes for Distributed Storage at the MSR and MBR Points via a Product-Matrix Construction", published on IEEE Transactions on Information Theory, vol. 57, 2011, pp. 5227-5239. Product-matrix regenerating codes rely on specific encoding and decoding algorithms and are not defined using a generator matrix as usual linear codes. The $k\Delta$ original blocks of $X$ are arranged (with repetitions and zero's) into a message matrix $M$ of dimension $d \times \alpha$ in a way specific to MSR or MBR. The code is defined by its encoding matrix $\Psi$ of dimension $n \times d$.

Regenerating codes have been mainly studied with respect to either theoretical aspects *(i.e.,* existence) or cost in bandwidth. Beside these studies, a few studies have looked at system aspects of regenerating codes, including encoding/decoding throughput *(i.e.,* CPU cost). The throughputs reported are 50KBps ($k = 32$, $d = 63$), 0.6 MBps ($k = 16$, $d = 30$) and even 100 MBps ($k = 2$, $d = 3$) in various publications, while RS codes encode at rates of about 1640 MBps. So far, reported speeds, except for very low values of $k$, are incompatible with practical deployments.

It is, therefore, of interest, to propose regenerating codes which permit higher throughput compatible with current practical implementations. The present principles provide product-matrix regenerating codes designed for enhanced computational or throughput performance.

SUMMARY

The present principles provide a class of product-matrix (PM) regenerating codes named sparse-PM regenerating codes for fault-tolerance protection in a distributed storage system, designed for enhanced network bandwidth and computational performance. The codes are based on the Cauchy matrix. In particular, linear and systematic sparse-PM regenerating codes permit fast computations, allowing throughputs of up to about 790 MBps for typical settings. These throughputs are compatible with current practical deployments of erasure codes while presenting significant improvement in network bandwidth (network related repair cost).

According to one aspect of the present principles, a method of encoding data for fault-tolerance in a distributed storage system is provided, the distributed storage system including a plurality of storage nodes, the method including: accessing (510) a message matrix $M$ of dimension $d \times \alpha$ including a data message, wherein the data message includes $k \times \alpha$ symbols to be distributed over $k$ nodes; generating (520) a sparse-PM encoding matrix $\Psi$ for a ($n, k, d, \alpha$) MSR sparse-PM regenerating code based on the Cauchy matrix; and encoding (530) the data message according to the message matrix $M$ and the sparse-PM encoding matrix $\Psi$ of the sparse-PM regenerating code, wherein the encoded data is C = $\Psi M$ and is distributed over $n$ nodes.

According to one aspect of the present principles, a method of encoding data for fault-tolerance in a distributed storage system is provided, the distributed storage system including a plurality of storage nodes, the method including: accessing (610) a data message $X$ including $k \times \alpha$ symbols to be distributed over $k$ nodes; accessing (620) an index matrix $L$ of dimension $2\alpha \times \alpha$; generating (630) a sparse-PM encoding matrix $\Psi$ for a ($n, k, d, \alpha$) MSR sparse-PM regenerating code based on the Cauchy matrix; transforming (640) the encoding matrix $\Psi$ (640) into a sparse-PM linear generator matrix G; and encoding (660) the data message according to the sparse-PM linear generator matrix G of the regenerating code, wherein the encoded data is $Y$ = G$X$ and is distributed over $n$ nodes. The sparse-PM linear generator matrix G is characterized by:
$$G_{\alpha i+j,l'} = \begin{cases} \Psi_{i,l}, & \text{if there exists } l \text{ such that } l' = L_{l,j} \\ 0, & \text{otherwise} \end{cases}$$
wherein $L$ is an index matrix of dimension $2\alpha \times \alpha$. The method may further include: transforming (650) the sparse-PM generator matrix $G$ into a systematic matrix prior to encoding the data message.

According to one aspect of the present principles, an apparatus for encoding data for fault-tolerance in a distributed storage system is provided, the distributed storage system including a plurality of storage nodes, the apparatus including a processor, for receiving at least one input/output; and at least one memory in signal communication with the processor, the processor being configured to: access a message matrix $M$ of dimension $\mathbf{d} \times \alpha$ including a data message, wherein the data message includes $k \times \alpha$ symbols to be distributed over $k$ nodes; generate a sparse-PM encoding matrix $\Psi$ for a $(n, k, d, \alpha)$ MSR sparse-PM regenerating code based on the Cauchy matrix; and encode the data message according to the message matrix $M$ and the sparse-PM encoding matrix $\Psi$ of the sparse-PM regenerating code, wherein the encoded data is $C = \Psi M$ and is distributed over $n$ nodes.

According to one aspect of the present principles, an apparatus of encoding data for fault-tolerance in a distributed storage system is provided, the distributed storage system including a plurality of storage nodes, the apparatus including a processor, for receiving at least one input/output; and at least one memory in signal communication with the processor, the processor being configured to: access a data message $X$ including $k \times \alpha$ symbols to be distributed over $k$ nodes; access an index matrix $L$ of dimension $2\alpha \times \alpha$; generate a sparse-PM encoding matrix $\Psi$ for a $(n, k, d, \alpha)$ MSR sparse-PM regenerating code based on the Cauchy matrix; transform the encoding matrix $\Psi$ (640) into a sparse-PM linear generator matrix $G$; and encode the data message according to the sparse-PM linear generator matrix $G$ of the regenerating code, wherein the encoded data is $Y = GX$ and is distributed over $n$ nodes. The sparse-PM linear generator matrix $G$ is characterized by:

$$G_{\alpha i+j, l'} = \begin{cases} \Psi_{i,l}, & \text{if there exists } l \text{ such that } l' = L_{l,j} \\ 0, & \text{otherwise} \end{cases},$$

wherein $L$ is an index matrix of dimension $2\alpha \times \alpha$. The processor may be further configured to: transform the sparse-PM generator matrix G into a systematic matrix prior to encoding the data message.

According to one aspect of the present principles, a method of regenerating or repairing data for fault-tolerance in a distributed storage system is provided, the distributed storage system including $n$ storage nodes, the method including: generating (710) a sparse-PM encoding matrix $\Psi$ for a $(n, k, d, \alpha)$ MSR sparse-PM regenerating code based on the Cauchy matrix; receiving (720) at least $d$ data values from at least $d$ nodes; regenerating (730) a failed storage node in the distributed storage system based on the data values and the sparse-PM encoding matrix $\Psi$. The data may be encoded using a linear systematic code derived from said sparse-PM regenerating code. The regenerating step of the method may further include: grouping (732) said data values into a data vector $V_{R1}$; calculating (734) an intermediate matrix $V_{R2}$ from said data vector; and calculating (736) the data stored in the failed storage node from said intermediate matrix, wherein said data comprises $\alpha$ symbols.

According to one aspect of the present principles, an apparatus for regenerating or repairing data for fault-tolerance in a distributed storage system is provided, the distributed storage system including $n$ storage nodes, the apparatus including a processor, for receiving at least one input/output; and at least one memory in signal communication with the processor, the processor being configured to: generate a sparse-PM encoding matrix $\Psi$ (520) for a $(n, k, d, \alpha)$ MSR sparse-PM regenerating code based on the Cauchy matrix; receive at least d data values from at least $d$ nodes; regenerate a failed storage node in the distributed storage system based on the data values and the sparse-PM encoding matrix $\Psi$. The data may be encoded using an equivalent linear systematic code derived from said sparse-PM regenerating code. The processor may be configured to regenerate by being further configured to: group said data values into a data vector $V_{R1}$; calculate an intermediate matrix $V_{R2}$ from said data vector $V_{R1}$; and calculate the data stored in the failed storage node from said intermediate matrix, wherein said data comprises $\alpha$ symbols.

According to one aspect of the present principles, a method of decoding data for fault-tolerance in a distributed storage system is provided, the distributed storage system including $n$ storage nodes, the method including: generating (810) a sparse-PM encoding matrix $\Psi$ for a $(n, k, d, \alpha)$ MSR sparse-PM regenerating code based on the Cauchy matrix; receiving (820) at least k data vectors from at least $k$ nodes; decoding (830) the data of the $n$ storage nodes in the distributed storage system based on the data vectors and the sparse-PM encoding matrix $\Psi$. The method may further include post-processing the decoded data resulting from the decoding step to recover an original data, the post-processing including applying the inverse of a systematic transformation, wherein the original data was pre-processed by the systematic transformation prior to encoding. The decoding step of the method may further include: grouping (832) said data vectors into a data matrix $V_{D1}$; calculating (834) an intermediate matrix $V_{D2}$ from said data vector; calculating (836) the symbols of data sub-matrices P and Q from said intermediate matrix; and calculating (838) a message matrix M of the distributed storage system from the data sub-matrices and said sparse-PM encoding matrix $\Psi$.

According to one aspect of the present principles, an apparatus for decoding data for fault-tolerance in a distributed storage system is provided, the distributed storage system including $n$ storage nodes, the apparatus including a processor, for receiving at least one input/output; and at least one memory in signal communication with the processor, the processor being configured to: generate a sparse-PM encoding matrix $\Psi$ (520) for a $(n, k, d, \alpha)$ MSR sparse-PM regenerating code based on the Cauchy matrix; receive at least $k$ data vectors from at least $k$ nodes; decode the data of the $n$ storage nodes in the distributed storage system based on the data vectors and the sparse-PM encoding matrix $\Psi$. The processor may be further configured to post-process the decoded data to recover an original data, by applying the inverse of a systematic transformation, wherein the original data was pre-processed by the systematic transformation prior to encoding. The processor may be configured to decode by being further configured to: group said data vectors into a data matrix $V_{D1}$; calculate an intermediate matrix $V_{D2}$ from said data vector; calculate the symbols of data sub-matrices $P$ and $Q$ from said intermediate matrix; and calculate a message matrix $M$ of the distributed storage system from the data sub-matrices and said sparse-PM encoding matrix $\Psi$.

According to one aspect of the present principles, a computer readable memory is provided including an MSR Product-Matrix regenerating code for providing fault-tolerance in a distributed storage system, the code comprising an sparse-PM encoding matrix $\Psi$ based on the Cauchy matrix.

According to one aspect of the present principles, a computer readable memory is provided including a code for providing fault-tolerance in a distributed storage system, the code comprising a linear generator matrix $G$ characterized by:

$$G_{\alpha i+j,l'} = \begin{cases} \Psi_{i,l}, \text{ if there exists } l \text{ such that } l' = L_{l,j} \\ 0, \text{ otherwise} \end{cases};\text{ wherein } L \text{ is an index matrix of dimension } 2\alpha$$

$\times\ \alpha$ and $\Psi$ is an encoding matrix of a sparse-PM regenerating code based on the Cauchy matrix.

According to one aspect of the present principles, a computer readable memory is provided including a code for providing fault-tolerance in a distributed storage system, the code comprising a systematic generator matrix $G'$, wherein $G'$ is a systematic transformation of a linear generator matrix $G$ which is characterized by:

$$G_{\alpha i+j,l'} = \begin{cases} \Psi_{i,l}, \text{ if there exists } l \text{ such that } l' = L_{l,j} \\ 0, \text{ otherwise} \end{cases};\text{ wherein } L \text{ is an index matrix of dimension } 2\alpha$$

$\times\ \alpha$ and $\Psi$ is an encoding matrix of a sparse-PM regenerating code based on the Cauchy matrix.

The present principles include the following:

1. A method of encoding data for fault-tolerance in a distributed storage system, said distributed storage system comprising a plurality of storage nodes, said method comprising:

accessing (510) a message matrix $M$ of dimension $d \times \alpha$ comprising a data message, wherein said data message comprises $k \times \alpha$ symbols to be distributed over $k$ nodes;
generating (520) a sparse-PM encoding matrix $\Psi$ for a $(n, k, d, \alpha)$ MSR sparse-PM regenerating code based on the Cauchy matrix; and
encoding (530) the data message according to said message matrix $M$ and said sparse-PM encoding matrix $\Psi$ of said sparse-PM regenerating code, wherein the encoded data is $C = \Psi M$ and is distributed over $n$ nodes.

2. The method of claim 1, wherein said sparse-PM encoding matrix comprises:

$\Psi = [\Phi\ \Lambda\Phi]$, $\Psi$ is a $n \times d$ matrix, $\Phi$ is a $n \times \alpha$ matrix and $\Lambda$ is a $n \times n$ diagonal matrix,

$$\Phi_{i,j} = \begin{cases} 0, \text{for all } i \neq j, i \leq \alpha \\ 1, \text{for all } i = j, i \leq \alpha \\ \dfrac{1}{a_i - b_j}, \text{otherwise} \end{cases}$$

$$\Lambda_{i,j} = \begin{cases} 0, \text{for all } i \neq j \\ \dfrac{a_i - b_1}{a_i - b_{\alpha+1}}, \text{otherwise} \end{cases}$$

$$a_i = g^{i+\alpha};$$

$$b_j = g^{j-1};$$

and

$g$ is a generator element of a finite field.

3. The method of claim 1 or 2, wherein said code is a systematic regenerating code.

4. A method of encoding data for fault-tolerance in a distributed storage system, said distributed storage system comprising a plurality of storage nodes, said method comprising:

accessing (610) a data message $X$ comprising $k \times \alpha$ symbols to be distributed over $k$ nodes;
accessing (620) an index matrix $L$ of dimension $2\alpha \times \alpha$;
generating (630) a sparse-PM encoding matrix $\Psi$ for a ($n, k, d, \alpha$) MSR sparse-PM regenerating code based on the Cauchy matrix;
transforming (640) said encoding matrix $\Psi$ (640) into a sparse-PM linear generator matrix $G$; and
encoding (660) the data message according to said sparse-PM linear generator matrix $G$ of said regenerating code, wherein the encoded data is Y = G$X$ and is distributed over $n$ nodes.

5. The method of claim 4, wherein said sparse-PM linear generator matrix G comprises:

$$G_{\alpha i+j,l'} = \begin{cases} \Psi_{i,l}, \text{ if there exists } l \text{ such that } l' = L_{l,j} \\ 0, \text{ otherwise} \end{cases}$$

wherein $L$ is an index matrix of dimension $2\alpha \times \alpha$.

6. The method of claim 4 or 5 further comprising:

transforming (650) said sparse-PM generator matrix $G$ into a systematic matrix prior to encoding said data message.

7. An apparatus for encoding data for fault-tolerance in a distributed storage system, said distributed storage system comprising a plurality of storage nodes, said apparatus comprising a processor, for receiving at least one input/output; and at least one memory in signal communication with said processor, said processor being configured to:

access a message matrix $M$ of dimension $d \times \alpha$ comprising a data message, wherein said data message comprises $k \times \alpha$ symbols to be distributed over $k$ nodes;
generate a sparse-PM encoding matrix $\Psi$ for a ($n, k, d, \alpha$) MSR sparse-PM regenerating code based on the Cauchy matrix; and
encode the data message according to said message matrix $M$ and said sparse-PM encoding matrix $\Psi$ of said sparse-PM regenerating code, wherein the encoded data is C = $\Psi M$ and is distributed over $n$ nodes.

8. The apparatus of claim 7, wherein said code is a systematic regenerating code.

9. An apparatus of encoding data for fault-tolerance in a distributed storage system, said distributed storage system comprising a plurality of storage nodes, said apparatus comprising a processor, for receiving at least one input/output; and at least one memory in signal communication with said processor, said processor being configured to:

access a data message $X$ comprising $k \times \alpha$ symbols to be distributed over $k$ nodes;
access an index matrix $L$ of dimension $2\alpha \times \alpha$;
generate a sparse-PM encoding matrix $\Psi$ for a ($n, k, d, \alpha$) MSR sparse-PM regenerating code based on the Cauchy matrix;
transform said encoding matrix $\Psi$ (640) into a sparse-PM linear generator matrix $G$; and
encode the data message according to said sparse-PM linear generator matrix $G$ of said regenerating code, wherein the encoded data is $Y = GX$ and is distributed over $n$ nodes.

10. The apparatus of claim 9, wherein said sparse-PM linear generator matrix G comprises:

$$G_{\alpha i + j, l'} = \begin{cases} \Psi_{i,l}, \text{ if there exists } l \text{ such that } l' = L_{l,j} \\ 0, \text{ otherwise} \end{cases}$$

wherein $L$ is an index matrix of dimension $2\alpha \times \alpha$.

11. The apparatus of claim 9 or 10, wherein the processor is further configured to:

transform said sparse-PM generator matrix $G$ into a systematic matrix prior to encoding said data message.

12. A method of regenerating data for fault-tolerance in a distributed storage system, said distributed storage system comprising $n$ storage nodes, said method comprising:

generating (710) a sparse-PM encoding matrix $\Psi$ for a ($n, k, d, \alpha$) MSR sparse-PM regenerating code based on the Cauchy matrix;
receiving (720) at least d data values from at least d nodes;
regenerating (730) a failed storage node in said distributed storage system based on said data values and said sparse-PM encoding matrix $\Psi$.

13. The method of claim 12, wherein the data was encoded using a linear systematic code derived from said sparse-PM regenerating code.

14. The method of claim 12 or 13, wherein said regenerating step further comprises:

grouping (732) said data values into a data vector $V_{R1}$;
calculating (734) an intermediate matrix $V_{R2}$ from said data vector; and
calculating (736) the data stored in the failed storage node from said intermediate matrix, wherein said data comprises $\alpha$ symbols.

15. An apparatus for regenerating data for fault-tolerance in a distributed storage system, said distributed storage system comprising $n$ storage nodes, said apparatus comprising a processor, for receiving at least one input/output; and at least one memory in signal communication with said processor, said processor being configured to:

generate a sparse-PM encoding matrix $\Psi$ (520) for a ($n, k, d, \alpha$) MSR sparse-PM regenerating code based on the Cauchy matrix;
receive at least $d$ data values from at least $d$ nodes;
regenerate a failed storage node in said distributed storage system based on said data values and said sparse-PM encoding matrix $\Psi$.

16. The apparatus of claim 15, wherein the data was encoded using a linear systematic code derived from said sparse-PM regenerating code.

17. The apparatus of claim 15 or 16, wherein said processor is configured to regenerate by being further configured to:

group said data values into a data vector $V_{R1}$;
calculate an intermediate matrix $V_{R2}$ from said data vector $V_{R1}$; and
calculate the data stored in the failed storage node from said intermediate matrix, wherein said data comprises $\alpha$ symbols.

18. A method of decoding data for fault-tolerance in a distributed storage system, said distributed storage system comprising $n$ storage nodes, said method comprising:

generating (810) a sparse-PM encoding matrix $\Psi$ for a ($n, k, d, \alpha$) MSR sparse-PM regenerating code based on the Cauchy matrix;
receiving (820) at least *k* data vectors from at least *k* nodes;
decoding (830) the data of the *n* storage nodes in said distributed storage system based on said data vectors and said sparse-PM encoding matrix Ψ.

19. The method of claim 18 further comprising:

post-processing (840) the decoded data resulting from the decoding step to recover an original data, said post-processing comprising applying the inverse of a systematic transformation, wherein said original data was pre-processed by said systematic transformation prior to encoding.

20. The method of claim 18 or 19, wherein said decoding step further comprises:

grouping (832) said data vectors into a data matrix $V_{D1}$;
calculating (834) an intermediate matrix $V_{D2}$ from said data vector;
calculating (836) the symbols of data sub-matrices P and Q from said intermediate matrix; and
calculating (838) a message matrix *M* of the distributed storage system from the data sub-matrices and said sparse-PM encoding matrix Ψ.

21. An apparatus for decoding data for fault-tolerance in a distributed storage system, said distributed storage system comprising *n* storage nodes, said apparatus comprising a processor, for receiving at least one input/output; and at least one memory in signal communication with said processor, said processor being configured to:

generate a sparse-PM encoding matrix Ψ (520) for a (*n, k, d, α*) MSR sparse-PM regenerating code based on the Cauchy matrix;
receive at least *k* data vectors from at least *k* nodes;
decode the data of the *n* storage nodes in said distributed storage system based on said data vectors and said sparse-PM encoding matrix Ψ.

22. The apparatus of claim 21, wherein said processor is further configured to:

post-process the decoded data to recover an original data, by applying the inverse of a systematic transformation, wherein said original data was pre-processed by said systematic transformation prior to encoding.

23. The apparatus of claim 21 or 22, wherein said processor is configured to decode by being further configured to:

group said data vectors into a data matrix $V_{D1}$;
calculate an intermediate matrix $V_{D2}$ from said data vector;
calculate the symbols of data sub-matrices *P* and *Q* from said intermediate matrix; and
calculate a message matrix *M* of the distributed storage system from the data sub-matrices and said sparse-PM encoding matrix Ψ.

24. A computer readable memory comprising an MSR Product-Matrix regenerating code for providing fault-tolerance in a distributed storage system, said code comprising a sparse-PM encoding matrix Ψ based on the Cauchy matrix.

25. A computer readable memory comprising a code for providing fault-tolerance in a distributed storage system, said code comprising a linear generator matrix *G* characterized by:

$$G_{\alpha i+j,l'} = \begin{cases} \Psi_{i,l}, \text{ if there exists } l \text{ such that } l' = L_{l,j} \\ \quad 0, \text{ otherwise} \end{cases}$$

wherein *L* is an index matrix of dimension $2\alpha \times \alpha$ and Ψ is an encoding matrix of a sparse-PM regenerating code based on the Cauchy matrix.

26. A computer readable memory comprising a code for providing fault-tolerance in a distributed storage system, said code comprising a systematic generator matrix *G'*, wherein G' is a systematic transformation of a linear generator matrix *G* characterized by:

$$G_{\alpha i+j,l'} = \begin{cases} \Psi_{i,l}, \text{ if there exists } l \text{ such that } l' = L_{l,j} \\ 0, \text{ otherwise} \end{cases}$$

wherein *L* is an index matrix of dimension $2\alpha \times \alpha$ and $\Psi$ is an encoding matrix of a sparse-PM regenerating code based on the Cauchy matrix.

Additional features and advantages of the present principles will be made apparent from the following detailed description of illustrative embodiments which proceeds with reference to the accompanying figures.

BRIEF DESCRIPTION OF THE DRAWINGS

The present principles may be better understood in accordance with the following exemplary figures briefly described below:

Figure 1 illustrates the trade-off curve of regenerating codes;
Figure 2 illustrates the evaluation of encoding performance for various implementations of MSR Product-Matrix codes and RS codes according to the present principles: (a) Throughput for non-systematic codes; (b) Throughput for systematic codes; (c) Initialization for non-systematic codes and (d) Initialization for systematic codes;
Figure 3 illustrates the evaluation of the impact of optimizations for encoding systematic product-matrix codes according to the present principles: (a) Specific and linearized Vanilla codes and (b) Specific and linearized Sparse-PM codes;
Figure 4 illustrates the evaluation of the impact of block size on encoding performance for various implementations of MSR Product-Matrix codes and RS codes according to the present principles: (a) Non-systematic codes and (b) Systematic codes;
Figure 5 illustrates the evaluation of regenerating performance for various implementations of MSR Product-Matrix codes and RS codes according to the present principles: (a) Throughput for non-systematic codes; and (b) Initialization for non-systematic codes;
Figure 6 illustrates the evaluation of decoding performance for various implementations of MSR Product-Matrix codes and RS codes according to the present principles: (a) Throughput for non-systematic codes; (b) Throughput for systematic codes; (c) Initialization for non-systematic codes and (d) Initialization for systematic codes;
Figure 7 illustrates a flowchart of a method of encoding data for fault-tolerance in a distributed storage system according to the present principles;
Figure 8 illustrates a flowchart of a method of encoding data for fault-tolerance in a distributed storage system according to the present principles;
Figure 9 illustrates a flowchart of a method of regenerating or repairing data for fault-tolerance in a distributed storage system according to the present principles;
Figure 10 illustrates a flowchart of a method of decoding data for fault-tolerance in a distributed storage system according to the present principles; and
Figure 11 illustrates a block diagram of a computing environment within which the methods of the present principles may be implemented and executed.

DETAILED DISCUSSION OF THE EMBODIMENTS

The present principles relate to fault tolerance in storage systems and in particular to product-matrix regenerating codes. Other than the inventive concept, several elements hereby discussed are well known and will not be described in detail. For example, other than the inventive concept, familiarity with error correcting codes, erasure codes, Reed-Solomon codes, regenerating codes and product-matrix codes is assumed and not described herein in detail. It should also be noted that the inventive concept may be implemented using conventional programming techniques, which, as such, will not be described herein.

To provide high storage capacity, large-scale distributed storage systems have been widely deployed in enterprises such as Google File System, Amazon Dynamo and Microsoft Azure. In such systems, data is striped across multiple nodes that offer local storage space. Nodes are interconnected over a networked environment, in the form of either clustered or wide-area settings. Ensuring data availability in distributed storage systems is critical, given that node failures are prevalent.

Traditional distributed storage systems support failures of individual devices by the use of replication or erasure correcting codes. An erasure correcting code encodes $k$ blocks of original data (column vector $X$) to $n$ blocks of encoded data (column vector $Y$); so that the $k$ original blocks can be recovered from any $k$ encoded blocks. The code can be defined by its generator matrix $G$ of dimension $n \times k$. The encoding operation is then mathematically expressed as $Y = GX$; and the decoding operation as $X = \tilde{G}^{-1}\tilde{Y}$ where $\tilde{G}$ (respectively $\tilde{Y}$) are the rows of $G$ (respectively $Y$) that correspond to the remaining encoded blocks. Each device or node in the distributed storage system stores one block of data.

A key feature of distributed storage systems is their ability to self-repair (i.e., to recreate lost encoded blocks whenever some device fails). Erasure correcting codes support such repair by decoding $k$ blocks and encoding them again. This implies the transfer of $k$ blocks to recreate a single lost block, leading to high network-related repair cost. In fact, while erasure correcting codes offer better storage efficiency than replication for similar fault tolerance, they incur higher CPU consumption, higher network consumption and higher disk I/Os. To address these issues, codes specific to storage systems have been designed. Their main feature is the ability to repair a single lost disk efficiently.

Regenerating codes have been designed as codes offering an optimal tradeoff between storage and network bandwidth (i.e., network-related repair cost). While the original work relied on randomized codes construction, it has been followed by numerous studies on how to build such codes including product-matrix regenerating codes which are applicable to a wide set of parameters.

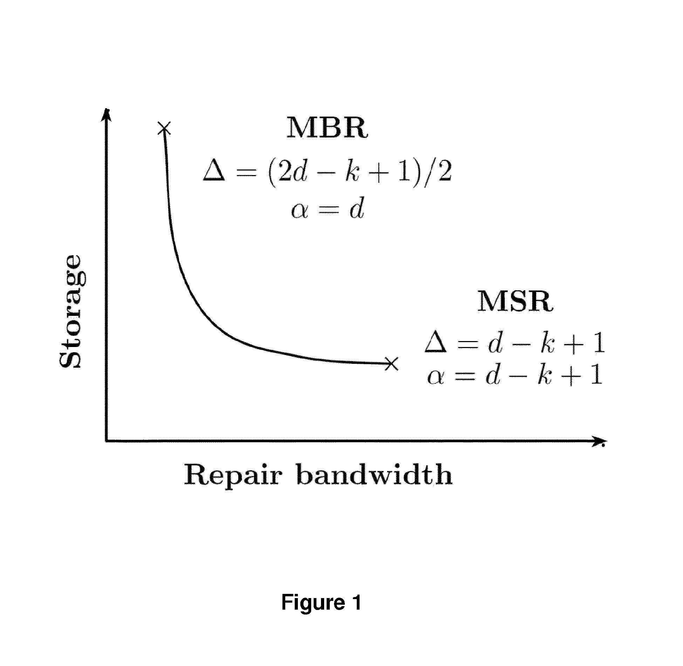

Regenerating codes achieve the optimal tradeoff between storage and bandwidth with two main variants: MSR codes which favor storage, and MBR codes which favor bandwidth. Figure 1 shows the trade-off curve of storage versus repair bandwidth with the two extreme cases. MSR codes encode $k\alpha$ blocks to $n\alpha$ blocks, wherein each device stores $\alpha$ blocks and $\alpha = \Delta = d - k + 1$. During repair, d blocks are transferred over the network. MBR codes are similar but have $\alpha = d$ and $\Delta = (2d - k + 1)/2$, thus resulting in higher storage costs but lower network bandwidth during repairs.

Regenerating codes can be implemented using linear codes. Similarly to regular erasure correcting codes, the code can be defined by its generator matrix G of dimension $n\alpha \times k\Delta$. The encoding operation is then expressed as $Y = GX$ (where $X$ is a column vector of $k\Delta$ blocks and $Y$ is a column vector of $n\alpha$ blocks); and the decoding operation as $X = \tilde{G}^{-1}\tilde{Y}$ where $\tilde{G}$ (respectively $\tilde{Y}$) are the rows of G (respectively $Y$) that correspond to the remaining encoded blocks. The factor $\alpha$ in dimensions comes from the fact that each device stores $\alpha$ instead of 1 block for erasure correcting codes. This allows devices using regenerating codes to repair $\alpha$ blocks by downloading 1 block from $d$ devices thus saving bandwidth when compared to erasure correcting codes that repair 1 block by downloading 1 block from $k$ devices. As a consequence, the encoding and decoding complexity come with an additional factor $\alpha\Delta$. Given that in a typical setting $\alpha \propto k$ and $\Delta \propto k$, the encoding and decoding complexity, which is $\Omega(k^2)$ for erasure correcting codes, become $\Omega(k^4)$ for regenerating codes.

Product-matrix regenerating codes rely on specific encoding and decoding algorithms and are not defined using a generator matrix as usual linear codes. The $k\Delta$ original blocks of $X$ are arranged (with repetitions and zeros) into a message matrix $M$ of dimension $d \times \alpha$ in a way specific to MSR or MBR. The code is defined by its encoding matrix $\Psi$ of dimension $n \times d$, whose $i^{th}$ row $\psi_i^t$ is the named the encoding vector of node $i$, and the superscript $t$ represents the transpose operation. The encoding vector is used to encode the message into the form in which it is stored within the $i^{th}$ node. The encoding operation is thus defined as $C = \Psi M$ such that $C$ is a $n \times \alpha$ code matrix containing the $n\alpha$ encoded blocks, whose $i^{th}$ row $c_i^t$ contains the $\alpha$ symbols stored by the $i^{th}$ node, that is, $c_i^t = \psi_i^t M$.

The common structure of the code matrices leads to common architectures for both data-reconstruction and exact-regeneration. Data-reconstruction or decoding amounts to recovering the message matrix $M$ from the $k$ symbols obtained from an arbitrary set of $k$ storage nodes. By denoting the set of $k$ nodes to which the data collector connects as $\{i_1, i_2, ..., i_k\}$, the $j^{th}$ node in this set passes on the message vector $\psi_{i_j}^t M$ to the data collector. The data collector thus obtains the product matrix $\Psi_{DC}M$, where $\Psi_{DC}$ is the submatrix of $\Psi$ consisting of the $k$ rows $\{i_1, i_2, ..., i_k\}$. It then uses the properties of the matrices $\Psi$ and $M$ to recover the message. The precise procedure for recovering $M$ is a function of the particular construction of the type of product-matrix regenerating code used (MSR or MBR) and are described in the seminal paper by Rashmi et al.

As noted above, each node in the network is associated to a distinct $d \times 1$ encoding vector $\psi_i$. In the regeneration process, one needs to call upon a related vector $\mu_i$ of length $\alpha$ that contains a subset of the components of $\psi_i$. To regenerate a failed node $f$, the node replacing the failed node connects to an arbitrary subset $\{h_1, h_2, ..., h_d\}$, of $d$ storage nodes which we will refer to as the d helper nodes. Each helper node passes on the inner product of the $\alpha$ symbols stored in it with $\mu_f$, to the replacement node: the helper node $h_j$ passes $\psi_{h_j}^t M \mu_f$. The replacement node thus obtains the product matrix $\Psi_{repair}M\mu_f$, where $\Psi_{repair}$ is the sub-matrix of $\Psi$ consisting of the d rows $\{h_1, h_2, ..., h_d\}$. From this it turns out that one can recover the desired symbols. Here again, the precise procedure is dependent on the particular construction.

Systematic Codes

A key feature of codes for storage, being erasure correcting codes or regenerating codes, is their ability to be transformed into systematic codes. A systematic erasure correcting code (respectively, systematic regenerating code) is a code such that the $k$ (respectively, $k\Delta$) first blocks of $Y$ are equal to the original data $X$. Systematic codes have two main advantages:

- Accessing data does not require decoding provided that none of the $k$ first devices has failed thus enhancing the performance of the common case. Even if the system is designed to tolerate failures, most of the time, the device storing the data accessed is likely to be available; and
- Encoding tends to be less costly as we only need to compute the $n - k$ (respectively, $n\alpha - k\Delta$) last rows of $Y$, the $k$ (respectively, $k\Delta$) first being equal to $X$ by construction.

The construction of systematic codes is based on the fact that encoding and decoding operations are commutative. Hence, one can pre-process the original data $X$ by applying the decoding to the original data $X$ to obtain precoded data $Z$ and then encoding $Z$ to obtain $Y$ such that $Y_{[1...k\alpha]} = X$. For linear codes, the encoding is thus defined as $Y = G\tilde{G}^{-1}X$, wherein $\tilde{G}$ corresponds to the $k\Delta$ first rows of $G$ and $\tilde{G}^{-1}$ is hereby referred to as a systematic transformation. Thus, the resulting systematic code is the result of applying a systematic transformation to the original generator matrix $G$ and has a generator matrix $G' = G\tilde{G}^{-1}$, such that $G' = [_I \; G'']^t$. By construction, $G'$ inherits appropriate properties (*e.g.,* all $k \times k$ (respectively, $k\alpha \times k\alpha$) sub-matrices are full-rank) from $G$ ensuring that it is an appropriate encoding matrix. An alternative could be to choose $G''$ such that $G' = [I \; G'']^t$ has the needed properties.

A skilled artisan will appreciate that decoding the systematic codes described above may be accomplished by applying the inverse of the systematic generator matrix $G'$. Equivalently decoding may be accomplished by obtaining the inverse of the generator matrix $G$ to recover $Z$, followed by a post-processing step of applying the inverse systematic transformation $\tilde{G}$ to $Z$ in order to recover the original data $X$.

While building $G'$ directly is possible for some codes, this is not easy for all codes. For MBR product-matrix codes, since the matrix $\Psi$ is less constrained, Rashmi et al. give a direct construction for a systematic encoding matrix $\Psi = [I \; \Psi'']^t$ thus leading to an efficient implementation. However, for MSR product-matrix regenerating codes, matrix $\Psi$ (from which $G$ can be derived) must satisfy several constraints to allow efficient repair. Hence, Rashmi et al. build systematic codes by successively decoding and encoding, that is, the message matrix $M$ must be transformed in a similar way as in the linear systematic codes described above. The message data is first pre-decoded such that, when encoding it, the end result will be a systematic code. However, such indirect construction has a significant impact on the computing cost and optimization beyond this construction is highly desirable.

Regenerating codes have been mainly studied for their saving in bandwidth, leaving aside computational performance. The prior art has implemented and measured the performance of various regenerating codes such as randomized codes achieving throughputs around 50KBps using a pure Java-based implementation ($k = 32$, $d = 63$), 100 MBps for very small codes ($k = 2$, $d = 3$). Implementations of deterministic codes have also been reported which achieve relatively higher speed such as 0.6 MBps ($k = 16$, $d = 30$) using a pure Java-based implementation. These reported encoding throughputs are a factor that is likely to limit the deployment of regenerating codes, since saving network bandwidth requires a significant increase in processing costs.

The present principles provide techniques and optimizations for implementing fast product matrix regenerating codes, therefore focusing on computational costs.

**Linearization of Product-Matrix Codes**

Regarding the implementation of erasure correcting codes, highly optimized libraries have been recently released and provide fast arithmetic on Galois Field, namely GF-Complete or linear codes, namely Jerasure 2.0. These two libraries are of interest for the implementation of product-matrix regenerating codes. Being deterministic codes, small finite fields (*e.g.,* $CF(2^8)$) are sufficient for product-matrix codes in typical settings (*e.g.,* $k = 8$); as a consequence the libraries can leverage the split-table technique [relying on SIMD (Single Structure Multiple Data) for efficient multiplications in Galois Field.

When implementing product matrix regenerating codes, two alternatives are possible, namely:

- Applying the algorithms described by Rashmi et. al or
- Transforming them to linear codes and using generic algorithms for linear codes such as the ones implemented in Jerasure.

A linear code (n, k) is generally defined by Y = GX, where G is the generator matrix of dimension $n \times k$, $X$ is the input message of dimension $k \times 1$ and $Y$ is the encoded output of dimension $n \times 1$. In order to obtain the linearized version of the product matrix code, one needs to create a $n\alpha \times k\Delta$ generator matrix $G$ for a given code. According to the present principles, linearization may be accomplished as described below.

First, construct an index matrix $L$ accordingly to the definition of the message matrix M, so that $M_{i,j} = X_{L_{i,j}}$. Alternatively, a skilled artisan may generate $L$ as the concatenation of two $\alpha \times \alpha$ symmetric matrices containing an arrangement of integers from 1 to $k\alpha$. For example, for an MSR code with $k = 3$, $\alpha = \Delta = 2$, the index matrix $L$ of dimension $2\alpha \times \alpha$ may be:

$$L = \begin{bmatrix} 1 & 2 & 4 & 5 \\ 2 & 3 & 5 & 6 \end{bmatrix}^{\mathrm{t}} \qquad (1)$$

Permutations of this case are also possible with similar results. For example, if 4 and 2, as well as 3 and 5 are exchanged the index matrix will be:

$$L = \begin{bmatrix} 1 & 4 & 2 & 3 \\ 4 & 5 & 3 & 6 \end{bmatrix}^{\mathrm{t}} \qquad (2)$$

Encoding by the product-matrix regenerating code is defined as $C = \Psi M$. For a linear regenerating code defined as $Y = GX$, the element $C_{i,j}$ and the corresponding element $Y_{\alpha i+j}$ are computed using:

$$C_{i,j} = \sum_{l=1}^{n} \Psi_{i,l} X_{L_{l,j}} \qquad Y_{\alpha i+j} = \sum_{l'=1}^{k\delta} G_{\alpha i+j,l'} X_{l'} \qquad (3)$$

For all $i,j$, we have $C_{i,j} = Y_{\alpha i+j}$. Applying a change of variable $l' = L_{l,j}$, and noticing that:

*(i)* By construction of M and $L$, no row nor column of $L$ has duplicate values;
*(ii)* The equality can hold only if $G_{\alpha i+j,l'} = 0$ for any $X_{l'}$ not present on the lefthand side, resulting in:

$$\sum_{l=1}^{n} \Psi_{i,l} X_{L_{l,j}} = \sum_{l=1}^{n} G_{\alpha i+j,L_{l,j}} X_{L_{l,j}} \qquad (4)$$

This implies that the generator matrix G as described below is equivalent to a product matrix code (MSR or MBR) defined by $\Psi$ and $L$.

$$G_{\alpha i+j,l'} = \begin{cases} \Psi_{i,l} & \text{if there exists } l \text{ such that } l' = L_{i,j} \\ 0, & \text{otherwise} \end{cases} \qquad (5)$$

As it will be later explained, there are additional benefits for linearizing product matrix codes since it also leads to significant improvement when using systematic codes. In addition, linearization allows for: (i) re-using libraries designed for regular erasure codes; and (ii) simpler zero-copy/lazy implementation *(i.e., decoding only lost blocks)* as it is a single step transformation.

**Sparse-PM *Codes***

For a general PM MSR regenerating code with d = *2k - 2*, at the MSR point, $\alpha = d$-$k + 1 = k - 1$ and hence, *d = 2$\alpha$* and B = $k\alpha = \alpha(\alpha + 1)$. This particular setting is the most interesting since one generally wants the lowest possible n (lowest amount of redundancy which is still high when $n = 2k - 1$ and $d = 2k - 2$), and MSR codes are particularly interesting since they have properties close to traditional error correcting codes except for the lower repair bandwidth. Rashmi et al. describes the following constraints on the encoding matrix $\Psi$ for $(n, k, d, \alpha)$ MSR codes with ***d** = 2k - 2*:

a) $\Psi = [\Phi \ \Lambda\Phi]$, where $\Phi$ is a $n \times \alpha$ matrix and $\Lambda$ is a $n \times n$ diagonal matrix.

b) Any d rows of Ψ are linearly independent.
c) Any $\alpha$ rows of Φ are linearly independent.
d) All values of Λ are distinct.

The suggested construction is to take Ψ as a Vandermonde matrix (*i.e.*, $\Phi_{i,j} = g^{(i-1)(j-1)}$) which satisfies all needed properties. For example, if *n = 5, k = 3, d = 4, $\alpha$ = 2* and the finite field used has a generator element *g*, this gives the following matrices:

$$
\Phi = \begin{pmatrix} 1 & 1 \\ 1 & g^1 \\ 1 & g^2 \\ 1 & g^3 \\ 1 & g^4 \end{pmatrix} \qquad \Lambda = \begin{pmatrix} 1 & & & & \\ & g^2 & & & \\ & & g^4 & & \\ & & & g^6 & \\ & & & & g^8 \end{pmatrix} \qquad (6)
$$

$$
\Psi = \begin{pmatrix} 1 & 1 & 1 & 1 \\ 1 & g^1 & g^2 & g^3 \\ 1 & g^2 & g^4 & g^6 \\ 1 & g^3 & g^6 & g^9 \\ 1 & g^4 & g^8 & g^{12} \end{pmatrix}
$$

Interestingly, such construction based on dense encoding matrix Ψ leads to sparse generator matrix **G** as shown on Table 1 (e.g., **G** contains 75% of zeros for *k* = 8). Sparsity is important as multiplications by zero can be skipped resulting in lower computational costs. However, when the code is turned into systematic form, sparsity is lost and the lower part of the resulting generator **G"** contains 0% of zeroes.

In order to reduce the computational cost of product-matrix MSR codes, the European patent application Serial No. 14306444.2 proposed an alternative construction which satisfies the conditions aforementioned but gives slightly sparser Ψ and **G** and much sparser systematic generator *G"*. It takes Φ as a Vandermonde matrix (*i.e.*, $\Phi_{i,j} = g^{(i-1)(j-1)}$) but sets $\Phi_{i,j} = 0$ for all $i \neq j$, $i \leq \alpha$. Λ is left unchanged with $\Lambda_{i,i} = g^{(i-1)\alpha}$. For *n = 5, k = 3, d = 4, $\alpha$ = 2* and a finite field having a generator element *g*, this gives the following matrices:

$$
\Phi = \begin{pmatrix} 1 & 0 \\ 0 & g^1 \\ 1 & g^2 \\ 1 & g^3 \\ 1 & g^4 \end{pmatrix} \qquad \Lambda = \begin{pmatrix} 1 & & & & \\ & g^2 & & & \\ & & g^4 & & \\ & & & g^6 & \\ & & & & g^8 \end{pmatrix} \qquad (7)
$$

$$
\Psi = \begin{pmatrix} 1 & 0 & 1 & 0 \\ 0 & g^1 & 0 & g^3 \\ 1 & g^2 & g^4 & g^6 \\ 1 & g^3 & g^6 & g^9 \\ 1 & g^4 & g^8 & g^{12} \end{pmatrix}
$$

One with skill in the art may observe (or computationally check) that the above conditions a-d on Φ, Ψ and Λ are still satisfied, so that the resulting codes, hereby called Sparse-PM regenerating codes are valid product-matrix MSR codes. The advantage of such codes can be better observed when one generates their linear and/or systematic equivalents, as previously described. Table 1 below shows the percentage of 0 of the corresponding linear generator matrix (*G* for non-systematic and *G"* for systematic) of the original PM (or vanilla) and the sparse-PM regenerating codes. The percentage of zero in a matrix represents the sparsity of the matrix, which is inversely proportional to the computational complexity. Therefore, the more zeroes, the faster the computation.

As shown in Table 1, the sparse-PM non-systematic codes are slightly sparser than the non-systematic vanilla (*i.e.* original) codes (*e.g.*, 85 % of zeroes for $k = 8$). However, the sparse-PM systematic codes are significantly sparser than systematic vanilla codes (*e.g.,* 75% instead of 0% for $k = 8$) thus leading to faster computation. This is important since most codes deployed are systematic.

For a general PM MSR regenerating code satisfying the properties above there are many possible ways of designing the message matrix *M.* An exemplary message matrix *M* is defined as:

$$ M = \begin{bmatrix} S_1 \\ S_2 \end{bmatrix} \qquad (8) $$

where $S_1$ and $S_2$ are symmetric matrices constructed such that the $\binom{\alpha + 1}{2}$ entries in the upper-triangular part of each of the two matrices are filled up by $\binom{\alpha + 1}{2}$ distinct message symbols. Thus, all the $B = \alpha(\alpha + 1)$ message symbols are contained in the two matrices $S_1$ and $S_2$. The entries in the strictly lower-triangular portion of the two matrices are chosen so as to make the matrices symmetric.

**Table 1**

| Code (n=2k-1, d=2k-2) | k=4 | k=8 | k=16 |
|---|---|---|---|
| Vanilla PM MSR (non-systematic) | 50 | 75 | 87 |
| Sparse-PM MSR (non-systematic) | 64 | 85 | 93 |
| Vanilla PM MSR (systematic) | 0 | 0 | 0 |
| Sparse-PM MSR (systematic) | 50 | 75 | 88 |

According to the present principles, the general concept of sparsity may also be applied for codes based on matrices other than the Vandermonde matrix. A second embodiment of Sparse-PM codes relies on Cauchy matrices, which require smaller finite fields and guarantee that $\Phi$ is invertible even on a finite field. All values of $\Lambda$ are distinct and any matrix formed from *d* rows is invertible: it is computationally easy to check that all *n* such matrices are invertible. Let us define $a_i = g^{i+\alpha}$, $b_j = g^{j-1}$. Then, $\lambda_{i,i} = (\alpha_i - b_1)/(\alpha_i - b_{1+\alpha})$ and $\lambda_{i,j} = 0$, for all $i \neq j$. In addition, $\Phi$ is defined as an identity matrix concatenated to a specific Cauchy matrix, that is:

$$ \Phi_{i,j} = \begin{cases} 1 & \text{, for all } i = j, i \leq \alpha \\ 0 & \text{, for all } i \neq j, i \leq \alpha \\ \frac{1}{(a_i - b_j)} & \text{, for all } \alpha < i \leq 2\alpha \end{cases} \qquad (9) $$

For the case of $k = 3$, $n = 5$, $d = 4$, $\alpha = 2$, the construction above results in the following Cauchy matrix based Sparse-PM matrices:

$$\Phi = \begin{pmatrix} 1 & 0 \\ 0 & 1 \\ (g^{2\alpha+1} - g^0)^{-1} & (g^{2\alpha+1} - g^1)^{-1} \\ (g^{2\alpha+2} - g^0)^{-1} & (g^{2\alpha+2} - g^1)^{-1} \\ (g^{2\alpha+3} - g^0)^{-1} & (g^{2\alpha+3} - g^1)^{-1} \end{pmatrix} \tag{10}$$

$$\Lambda = \begin{pmatrix} \dfrac{g^{\alpha+1} - g^0}{g^{\alpha+1} - g^\alpha} & & & & \\ & \dfrac{g^{\alpha+2} - g^0}{g^{\alpha+2} - g^\alpha} & & & \\ & & \dfrac{g^{2\alpha+1} - g^0}{g^{2\alpha+1} - g^\alpha} & & \\ & & & \dfrac{g^{2\alpha+2} - g^0}{g^{2\alpha+2} - g^\alpha} & \\ & & & & \dfrac{g^{2\alpha+3} - g^0}{g^{2\alpha+3} - g^\alpha} \end{pmatrix}$$

$$\Psi = \begin{pmatrix} 1 & 0 & \dfrac{g^{\alpha+1} - g^0}{g^{\alpha+1} - g^\alpha} & 0 \\ 0 & 1 & 0 & \dfrac{g^{\alpha+2} - g^0}{g^{\alpha+2} - g^\alpha} \\ (g^{2\alpha+1} - g^0)^{-1} & (g^{2\alpha+1} - g^1)^{-1} & (g^{2\alpha+1} - g^\alpha)^{-1} & \dfrac{g^{2\alpha+1} - g^0}{g^{2\alpha+1} - g^\alpha} \dfrac{1}{g^{2\alpha+1} - g^1} \\ (g^{2\alpha+2} - g^0)^{-1} & (g^{2\alpha+2} - g^1)^{-1} & (g^{2\alpha+2} - g^\alpha)^{-1} & \dfrac{g^{2\alpha+2} - g^0}{g^{2\alpha+2} - g^\alpha} \dfrac{1}{g^{2\alpha+2} - g^1} \\ (g^{2\alpha+3} - g^0)^{-1} & (g^{2\alpha+3} - g^1)^{-1} & (g^{2\alpha+3} - g^\alpha)^{-1} & \dfrac{g^{2\alpha+3} - g^0}{g^{2\alpha+3} - g^\alpha} \dfrac{1}{g^{2\alpha+3} - g^1} \end{pmatrix}$$

By construction, any $k$ rows of $\Phi$ are invertible; and for a given finite field and $k$, it is easy to check computationally that all $n$ values of $\Lambda$ are different and that all $n$ possible $d \times$ d sub-matrices of $\Phi$ are invertible. The construction above is valid for $k \in [2, ... ,39]$ in the default Galois Field GF($2^8$) from GF-Complete and $k \in [2, ...,64]$ in GF($2^{16}$). Notice that the number of matrices to computationally check is small so that checking all the conditions for all $k$ takes 0.6 seconds in GF($2^8$) and 19 seconds for checking up to $k = 64$ in GF($2^{16}$).

The Cauchy matrix based Sparse-PM regenerating codes have the same performance as the Vandermonde matrix based construction. The main advantage is that Cauchy-based codes have stronger theoretical guarantees.. For example, the Vandermonde matrix based codes do not exist (may not be repaired in some cases) for $k = 9$ and $w = 8$ (where $w$ defines a finite field $F_q$ of size $q = 2^w$). due to properties specific to Vandermonde matrices in finite fields. In addition, Table 1 also applies to Cauchy-based sparse-PM codes.

**Regeneration/Repair**

For the codes presented in equations (6)-(10) above, exact-regeneration or repair of any failed node can be achieved by connecting to any d of the remaining $n$ - 1 nodes, called helper nodes, $\{h_1, h_2, ..., h_d\}$. Assuming that

$\begin{bmatrix} \phi_f^t & \lambda_f \phi_f^t \end{bmatrix}$ is the row of $\Psi$ corresponding to the failed node $f$, the $\alpha$ symbols previously stored in the failed node are defined by:

$$V_{R3} = \begin{bmatrix} \phi_f^t & \lambda_f \phi_f^t \end{bmatrix} M = \phi_f^t S_1 + \lambda_f \phi_f^t S_2 \quad (11)$$

Upon being contacted by the replacement node, the helper node $h_j$ computes the inner product $V_{R1,j} = \psi_{h_j}^t M \phi_f$ for $j = 1, ..., d$ and passes on this data value to the replacement node. Thus in the present construction, the vector $\mu_f$ equals $\Phi_f$ The replacement node thus obtains the d symbols and groups them into a data vector $V_{R1} = \Psi_{repair} M \Phi_f$ from the helper nodes, where:

$$\Psi_{repair} = \begin{bmatrix} \psi_{h1}^t \\ \psi_{h2}^t \\ \vdots \\ \psi_{hd}^t \end{bmatrix} \quad (12)$$

By construction, the $dxd$ matrix $\Psi_{repair}$ is invertible, i.e., $\Psi_{repair}^{-1}$ exists. Thus the replacement node now has access to an intermediate matrix:

$$V_{R2} = \Psi_{repair}^{-1} V_{R1} = \Psi_{repair}^{-1} \Psi_{repair} M \phi_f = M \phi_f = \begin{bmatrix} S_1 \phi_f \\ S_2 \phi_f \end{bmatrix} \quad (13)$$

Since $S_1$ and $S_2$ are symmetric matrices, the replacement node has thus acquired through transposition, both $\phi_f^t S_1$ and $\phi_f^t S_2$, which it can use together with $\lambda_f$ to obtain the data $V_{R3}$ previously stored in the failed node, as described in equation (11) above.

One skilled in the art will recognize that the operation of regeneration described above also applies to the linear and systematic versions of a regenerating PM code, since it consists in repairing the stored encoded data in one or more storage nodes. Although the systematic version of the code creates an equivalent code, it corresponds to pre-processing the original input data $X$ to obtain precoded data $Z$ followed by encoding $Z$ to obtain $Y$, such that $Y[1...k\alpha] = X$. Encoding $Z$ is performed with the non-systematic version of the code, by utilizing the generator matrix $G$ (in the linear version) or by utilizing the encoding matrix $\Psi$ and the message matrix M. Therefore, regenerating or repairing one or more nodes of $Y$ can still be accomplished through the regeneration method described above.

Reconstruction/Decoding

Similarly, regarding reconstruction or decoding for the codes presented in equations (6)-(8) above, all the $B$ message symbols can be recovered/reconstructed/decoded by connecting to any $k$ nodes, *i.e.,* the message symbols can be recovered through linear operations on the entries of any $k$ rows of the code matrix $C$. Assuming that $\Psi_{DC} = [\Phi_{DC} \; \Lambda_{DC}\Phi_{DC}]$ is the $k \times d$ submatrix of $\Psi$, containing the rows which correspond to the nodes to which the data collector connects, the data collector obtains the symbols of a $k \times \alpha$ data matrix:

$$V_{D1} = \Psi_{DC} M = \begin{bmatrix} \Phi_{DC} S_1 & \Lambda_{DC} \Phi_{DC} S_2 \end{bmatrix} \quad (12)$$

The data collector can post-multiply this term with $\Phi_{DC}^t$ to obtain an intermediate matrix:

$$V_{D2} = V_{D1} \Phi_{DC}^t = P + \Lambda_{DC} Q = \Phi_{DC} S_1 \Phi_{DC}^t + \Lambda_{DC} \Phi_{DC} S_2 \Phi_{DC}^t \quad (13)$$

Since $S_1$ and $S_2$ are symmetric, the same is true for the intermediate sub-matrices P and Q. The data collector has access to the symbols of the matrix above. Due to the symmetry of P and Q, the $(i,j)^{th}$, $1 \le i,j \le$ k element of this matrix is:

$$P_{i,j} + \lambda_i Q_{i,j} = P_{j,i} + \lambda_i Q_{j,i}$$

$$P_{j,i} + \lambda_j Q_{j,i} = P_{i,j} + \lambda_j Q_{i,j} \qquad (14)$$

By construction, all the $\lambda_i$ are distinct, so the data collector can use the equations above to solve for the values of $P_{i,j}$, $Q_{i,j}$ for all $i \ne j$. Hence, all the non-diagonal elements of P and $Q$ are known.

Assuming $\Phi_{DC} = \begin{bmatrix} \phi_1^t & \phi_2^t & \cdots & \phi_{\alpha+1}^t \end{bmatrix}^t$, the element in the $i^{th}$ row of P (excluding the diagonal elements) is given by:

$$V_{D3} = \phi_i^t S_1 \begin{bmatrix} \phi_1 & \cdots & \phi_{i-1} & \phi_{i+1} & \cdots & \phi_{\alpha+1} \end{bmatrix} \quad (15)$$

However, the matrix to the right is non-singular by construction and hence the data collector can obtain $V_{D4} = \phi_i^t S_1$ for $1 \le i \le \alpha + 1$. By selecting the first of these, the data collector has access to $V_{D5} = \begin{bmatrix} \phi_1^t & \phi_2^t & \cdots & \phi_\alpha^t \end{bmatrix}^t S_1$. Since the matrix on the left of $S_1$ is also non-singular by construction, the data collector can recover $S_1$. Similarly, by using the values of the non-diagonal elements of $Q$, the data collector can recover $S_2$. Hence, the entire message matrix $M$ is recovered/reconstructed.

Rashmi et al. has proven that MSR PM regenerating codes for $d$ = 2k - 2 can be used to obtain MSR codes for all d > 2$k$ - 2. Therefore, a skilled artisan will appreciate that this fact is also applicable to all sparse-PM regenerating codes of the present principles

For a linearized version of the code, reconstructing large amounts of data through the inverse generator matrix $G^{-1}$ may be more efficient than the reconstruction described above, even if the initialization cost is higher. Obtaining the inverse generator matrix may be accomplished, for example, through Gaussian Elimination (GE). Hence as long as what is gained on reconstructing exceeds the initialization cost, the linearized reconstruction is more efficient.

GE consists in performing elementary operations in the rows and columns of a generator matrix in two major steps: triangularization step and back-substitution step. In the triangularization step, the goal is to convert the given matrix using row operations and row and column re-orderings into an upper triangular square matrix having 1's along the diagonal and 0's below the diagonal after discarding bottom rows if any. If the triangularization step is successful, then the back-substitution step can proceed by converting the triangular matrix into the identity matrix after which the GE is successfully finished. Once the identity matrix is obtained the corresponding symbols can be obtained.

Although there is an equality between a regenerating code and its linear generator matrix $G$ in equation (5), the same is not the case for the systematic version of the code derived from $G$. The linear operations necessary to transform $G$ into a systematic generator matrix $G'$ create an equivalent code with similar properties, but not the same code. However, as previously described, the operation of obtaining a systematic linear code consists in the concatenation of two operations: pre-processing the original input data $X$ by pre-decoding it by the linear code $(\tilde{G}^{-1})$ to obtain precoded data $Z$ followed by encoding by $G$ to obtain the encoded data $Y = G\tilde{G}^{-1}X$, wherein $\tilde{G}$ corresponds to the $k\Delta$ first rows of $G$. The systematic code is then described by the generator matrix $G' = G\tilde{G}^{-1} = [I \ G''']^t$. As a result, decoding becomes simple, since the input data $X$ is directly available in the encoded message. However, if the data $X$ cannot be completely and directly recovered/accessed due to node failures, it can still be retrieved from decoding some of the remaining encoded symbols encoded by $G'$ (or more specifically, $G''$).

A skilled artisan will understand that decoding the systematic codes described above may be accomplished by applying the inverse of the systematic generator matrix $G'$. Equivalently decoding may be accomplished by obtaining the inverse of the generator matrix $G$ to recover $Z$, followed by a post-processing step of applying the inverse systematic transformation $\tilde{G}$ to $Z$ in order to recover the original data $X$. Furthermore, decoding of a systematic regenerating code above may be accomplished by the traditional decoding method of equations (14)-(17) above followed by the above described post-processing step.

**Evaluation**

An evaluation of the computational cost of product-matrix regenerating codes was performed by implementing them using the libraries GF-Complete (for the specific version) and Jerasure 2.0 (for the linearized version). Benchmarks were run on a Core Xeon E5-2640

(2.5 GHz) which supports SSE (up to 4.2) and AVX instructions set. Each result shown is the average over 1000 runs. All benchmarks correspond to single threaded computation *(i.e.,* use a single core).

For each operation, the total running time was separated into: (i) initialization time of encoding/decoding procedures (e.g., building generator or encoding matrix, inverting it) and *(ii)* time needed to apply the encoding/decoding procedures to the data (reported as the corresponding throughput in MBps - Mega Bytes per second). This distinction is important, as in a practical deployment, depending on the operation, the initialization phase could be pre-computed and its result stored once for all (e.g., encoding), or must be computed at for each operation as it depends on the failure pattern (e.g., decoding) but can be reused across stripes for large objects. The encoding/decoding throughput is the time taken to perform the operation divided by the amount of data to encode/decode (i.e., ka). The repair throughput is the time taken to perform the operation divided by the amount of data to repair (i.e., a).

The following codes were evaluated:

- Specific Vanilla Product-Matrix (PMXSVan = systematic; PMXNVan = non-systematic) are the prior art codes of equation (6).
- Specific Sparse Product-Matrix (PMXSSpa = systematic; PMXNSpa = non-systematic) are the Cauchy-based sparse PM regenerating codes according to the present principles with encoding based on the matrices $\Psi$ and M (equation 7).
- Linear Vanilla Product-Matrix (PMLSVan = systematic; PMLNVan = non-systematic) are the linearized version of the prior art codes of equation (6).
- Linear Sparse Product-Matrix (PMLSSpa = systematic; PMLNSpa = non-systematic) are the linearized version the Cauchy-based sparse PM regenerating codes according to the present principles (equation 7).
- Reed-Solomon Codes (RSLSSpa) are Vandermonde-based Reed-Solomon codes implemented in Jerasure and are used as a baseline for comparison.

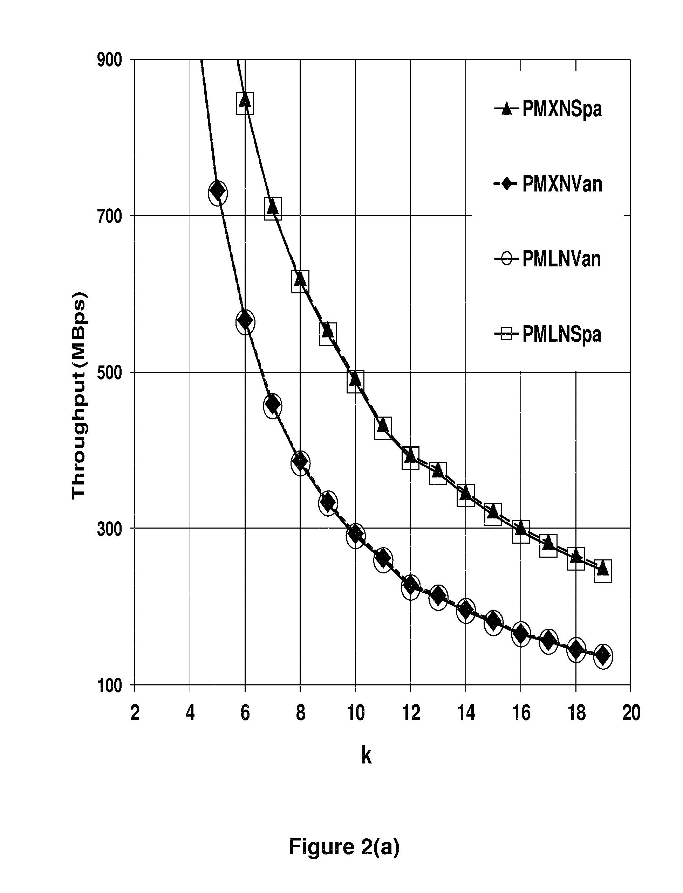

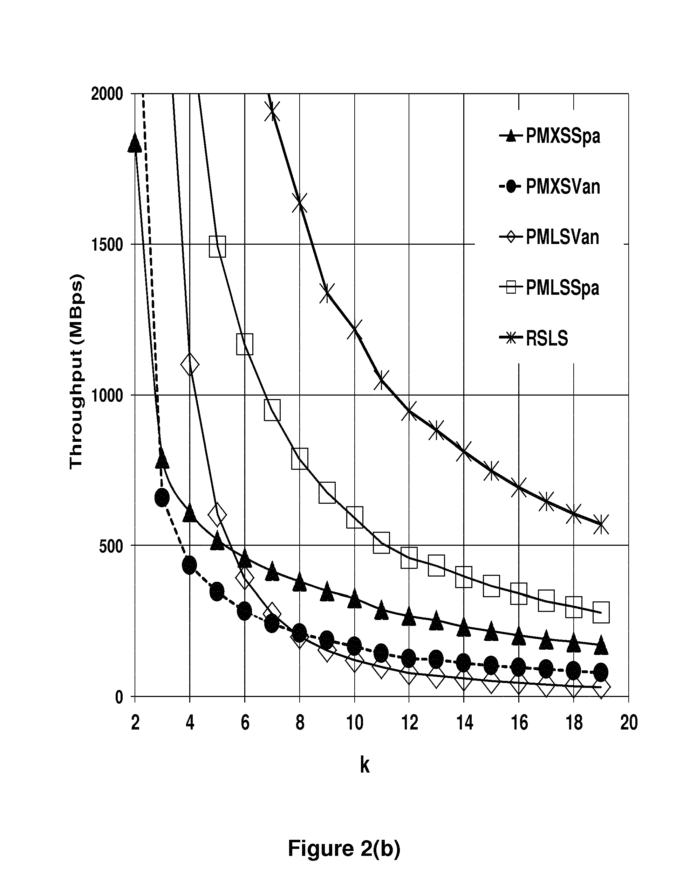

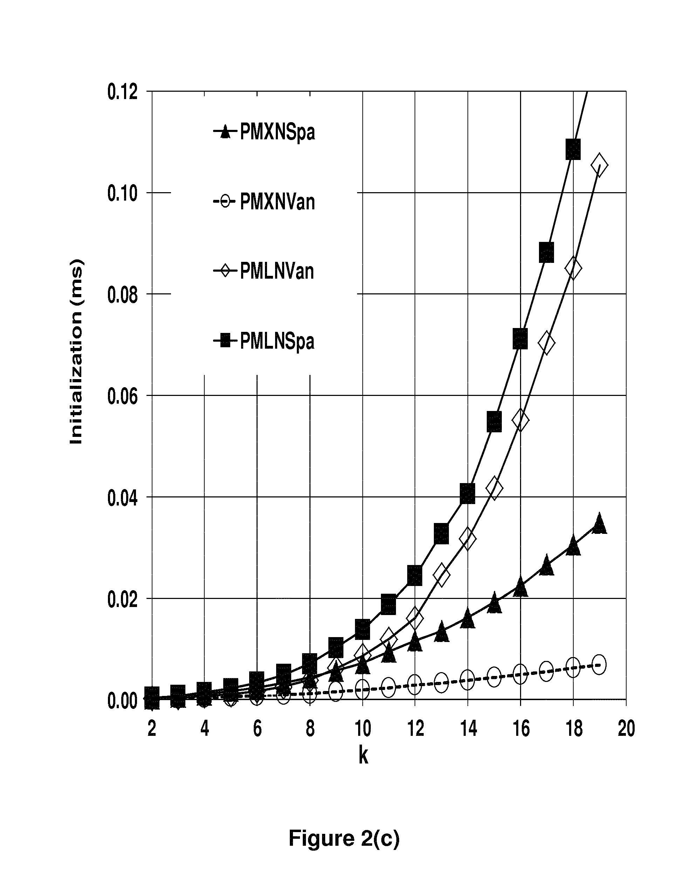

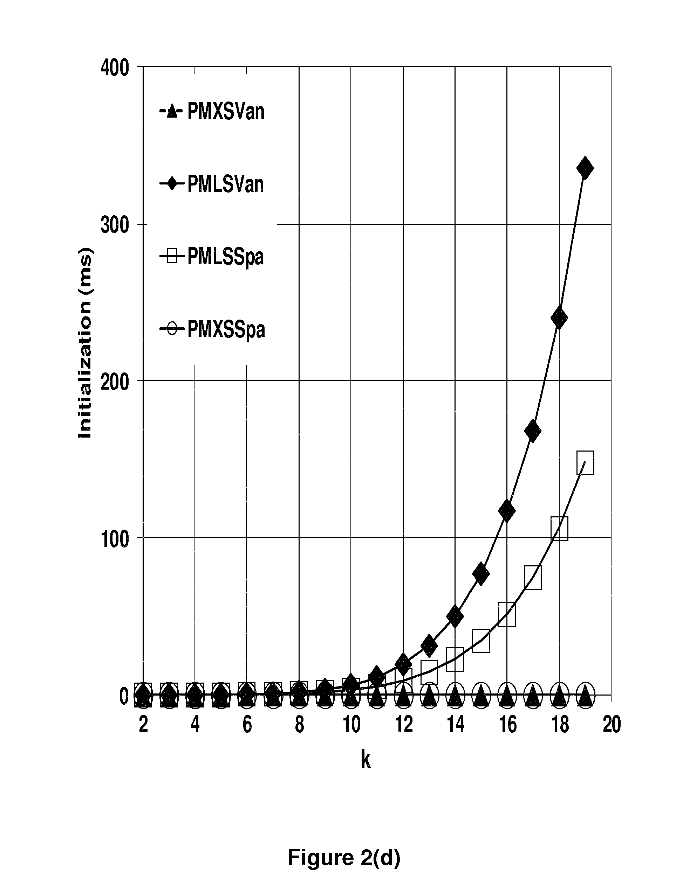

Figure 2 shows the performance of encoding operations. Overall, for typical settings such as $k = 8$, an appropriate choice of implementation *(i.e.,* systematic, sparse and linearized) allows encoding at about 790 MBps using product-matrix codes, when Reed-Solomon codes for the same setting achieve about 1640 MBps and the systematic vanilla PM codes achieve 210 MBps. Hence, the performance of the optimized product-matrix codes is good and they are a reasonable alternative to Reed-Solomon codes for practical deployment. Converting to a bit-matrix and computing a schedule is less efficient than using SIMD for Galois Field multiplication, leading to slower systematic encoding at 263 MBps for vanilla PM codes, and 314 MBps for sparse PM codes for $k = 8$ and blocks of 16 KB.

Using sparser codes has a positive impact on both non-systematic and systematic codes doubling the throughput. Linearizing the code is useful for systematic codes; it allows encoding directly without performing the pre-decoding step thus doubling again the throughput. Notice that the performance of sparse systematic codes is higher than sparse non-systematic codes because the $k\alpha$ first symbols need not be computed for systematic codes as they are equal to uncoded symbols.

As can be seen on Figures 2(c) and 2(d), the gain observed in throughput for using linearized systematic product-matrix codes comes at the price of a higher initialization cost *(i.e.,* time needed to compute the systematic generator matrix). However, since the generator (encoding) matrix is constant; it can be computed once and reused for all other encoding. Figures 2(c) and 2(d) show that, for non-systematic and systematic codes, the specific codes have a negligible initialization time compared with the linear ones. Also, although not shown in Figure 2(d), the RS codes also have negligible initialization time.

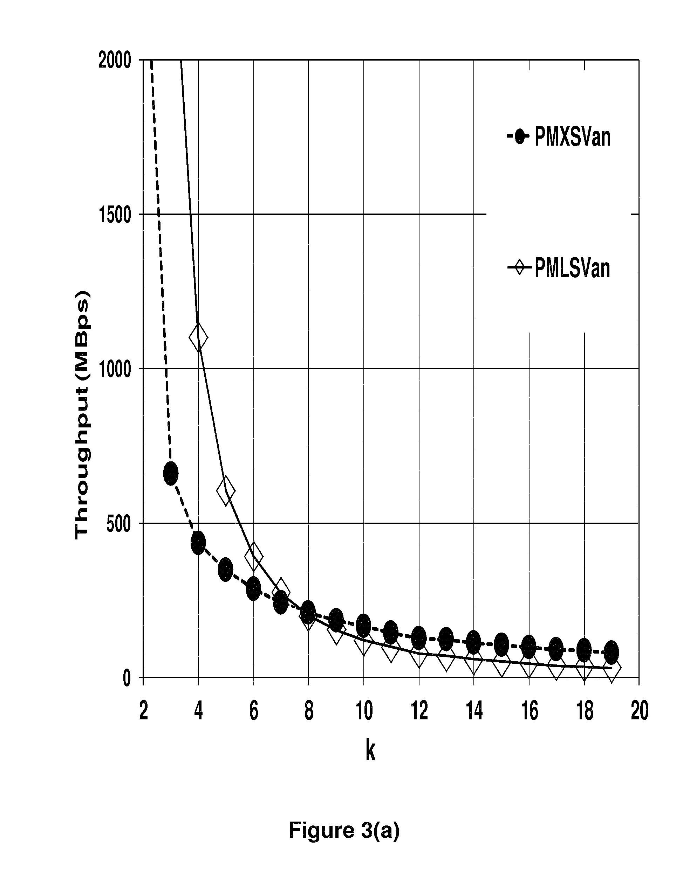

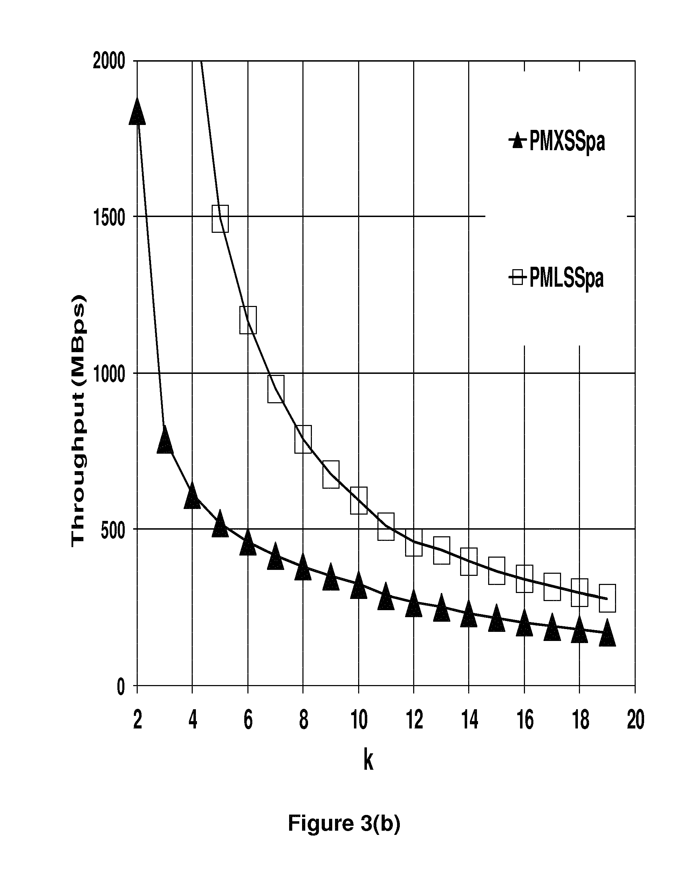

The individual effects of the various optimizations can be seen on Figure 3. From Figures 3(a) and 3(b), it can be observed that the linearized version is less efficient than the specific for large values of $k$ when using the vanilla code. In addition, the linearized and specific versions remain very close in performance throughout, except for small values of $k$. When using the sparse-PM code, the performance is substantially increased by linearization, except for large values of $k$. This is due to the fact that the generator matrix is not sparse for the systematic vanilla code. Hence, the two optimizations described (sparsity and linearity of the code) should be applied together: Even if they increase the performance on their own, their combination provides a significant enhancement, since sparsification allows to better leverage the gains from linearization. The performance of the linearized and specific versions converge to similar values for large values of $k$

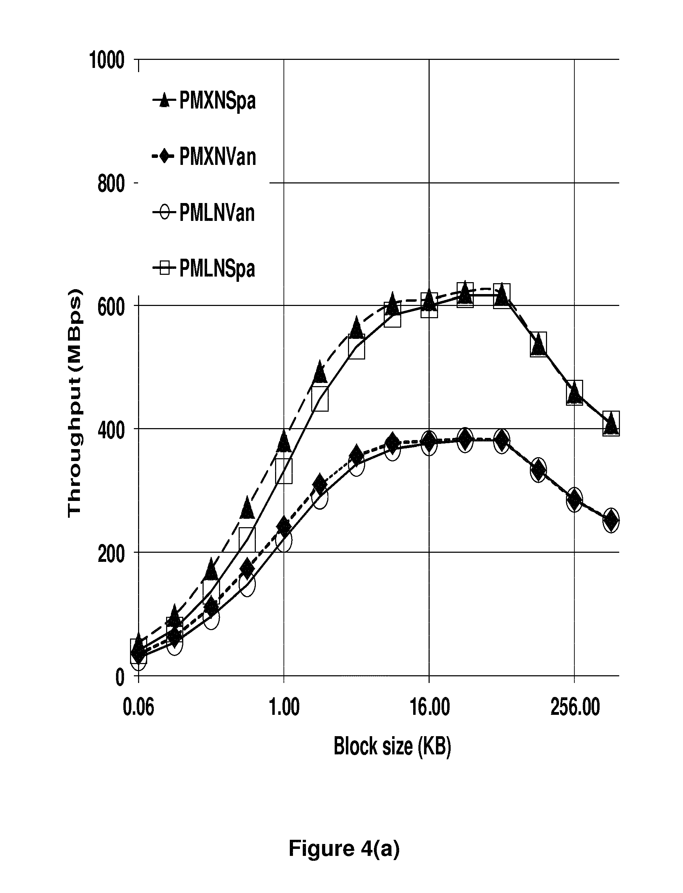

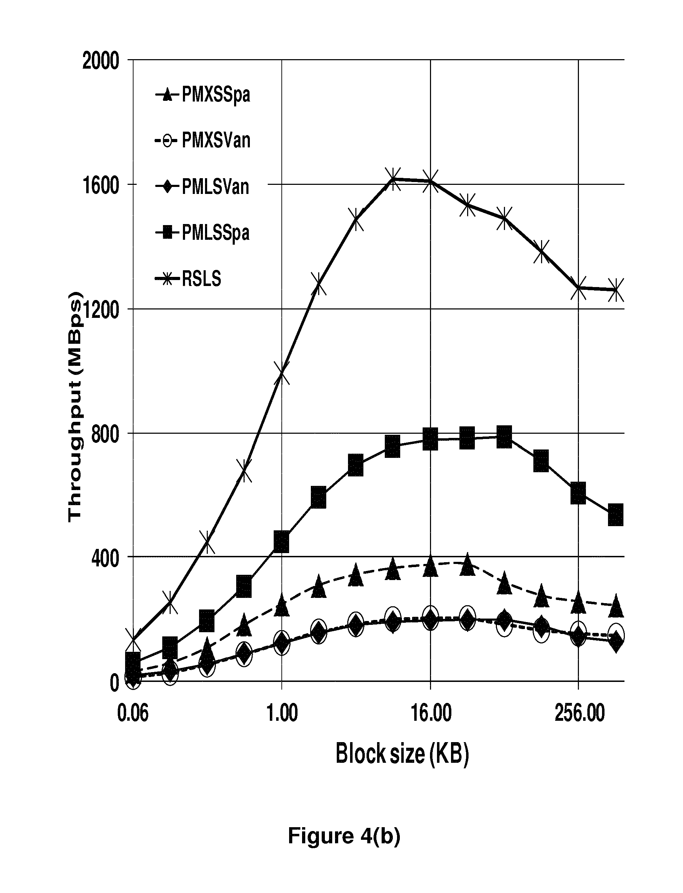

Figure 4 shows the impact of block size on encoding performance for various implementations of MSR PM regenerating codes and RS codes and $k = 8$. Figure 4(a) is for non-systematic codes and 4(b) is for systematic codes. These curves show a preferred block size around 16KB to 32KB for all codes. This is consistent with the size of the L1 cache of the processor, which is 32 KB. Similar results can be observed for decoding, repair and also for MBR codes. Hence, all other experiments use 16 KB as the block size. The figures also show the advantage of utilizing systematic and linear sparse-PM codes and how close these codes come to the RS codes in computational performance.

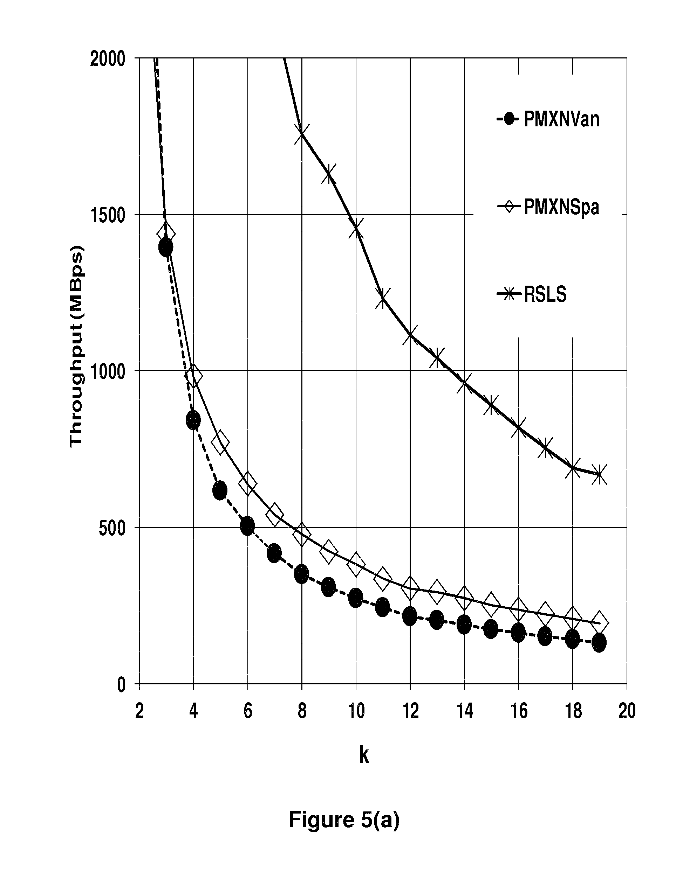

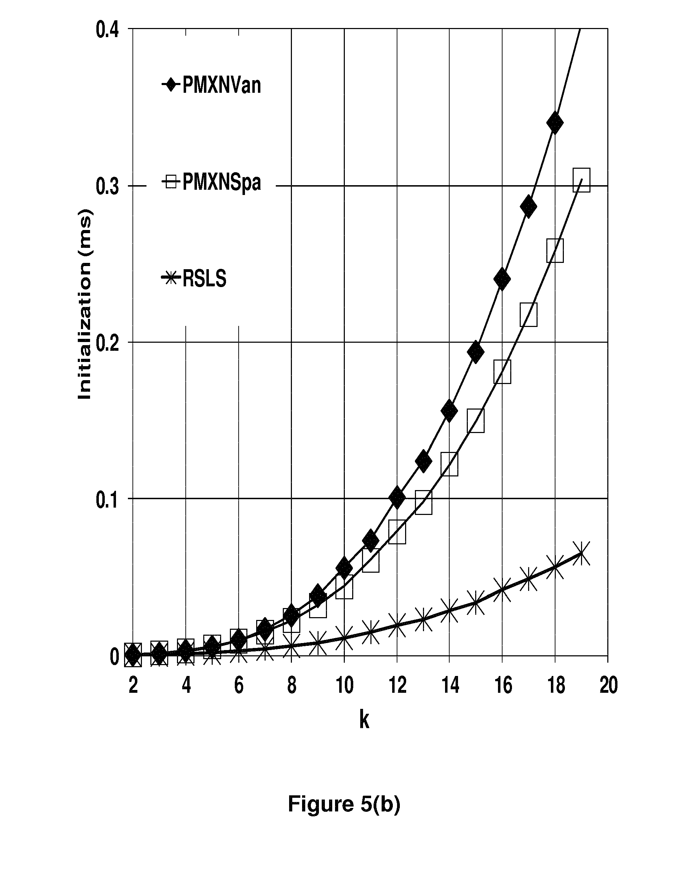

Figure 5 shows the performance of the repair operation for a single failure. In order to measure the performance, the computation, which consists of several independent sub-computations, is performed sequentially on a single core. Sparse PM codes are slightly faster than vanilla codes and are operating at 480 MBps when Reed-Solomon codes operate at 1830 MBps

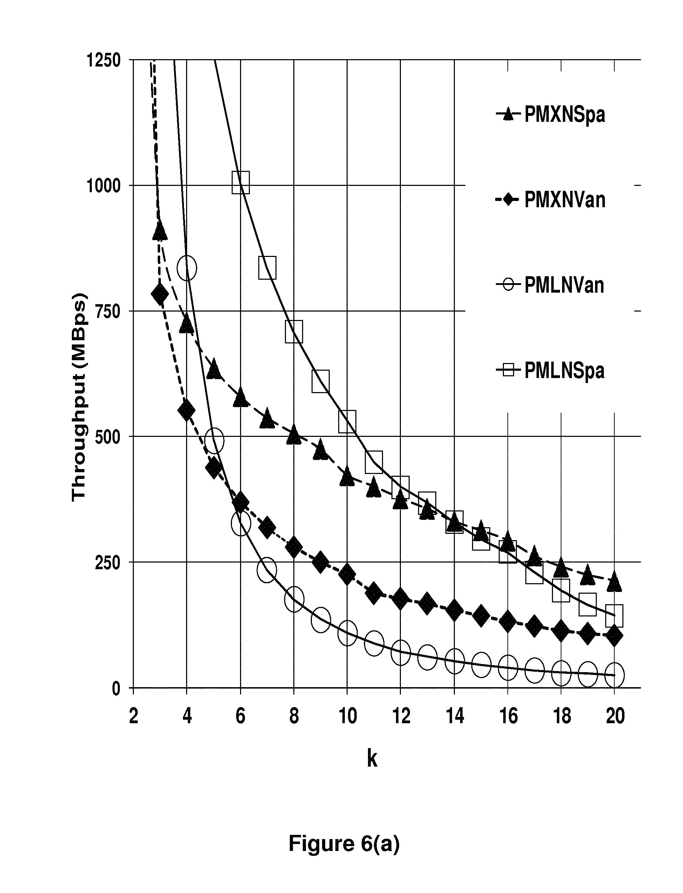

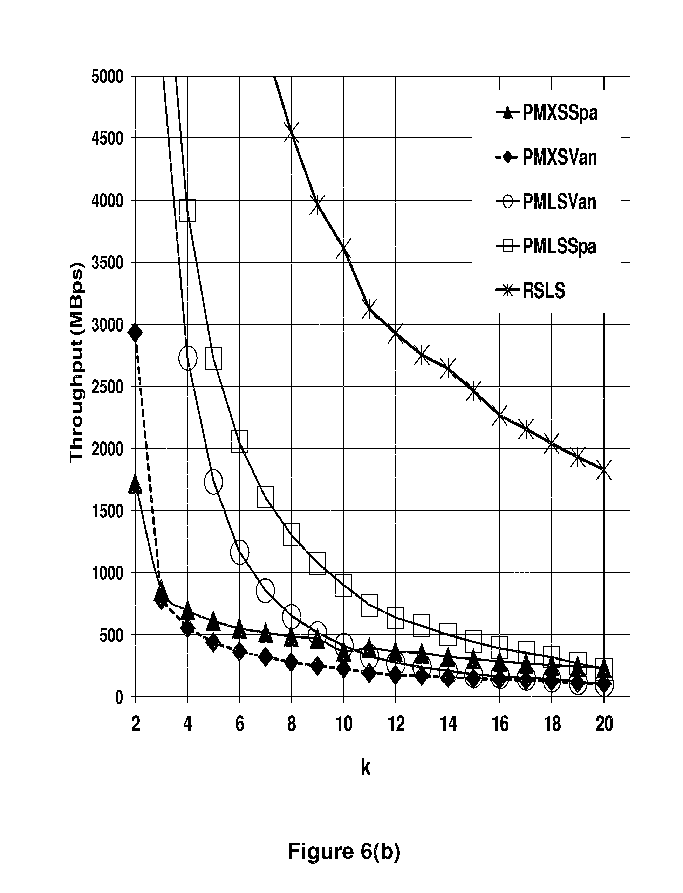

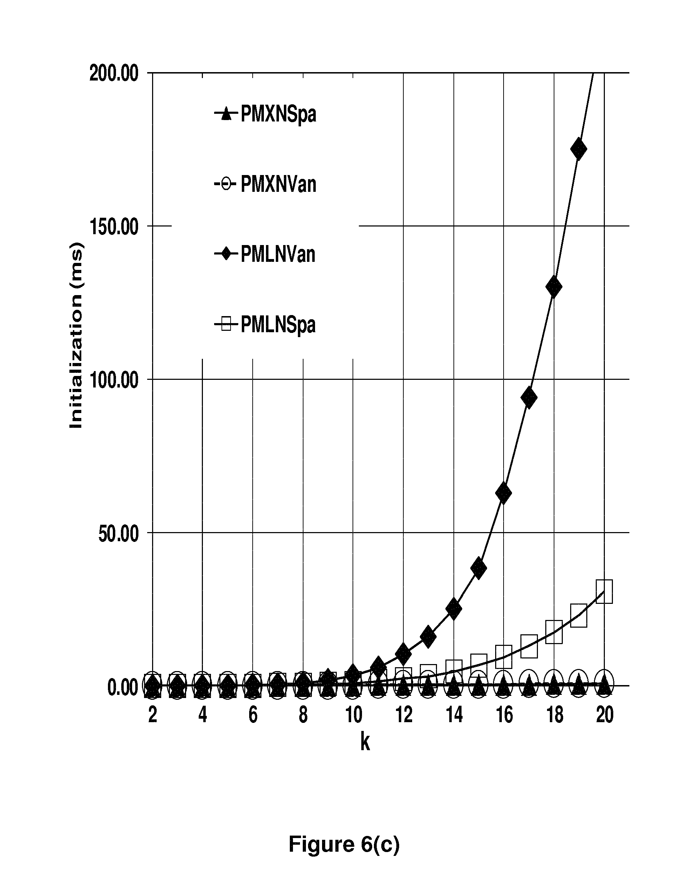

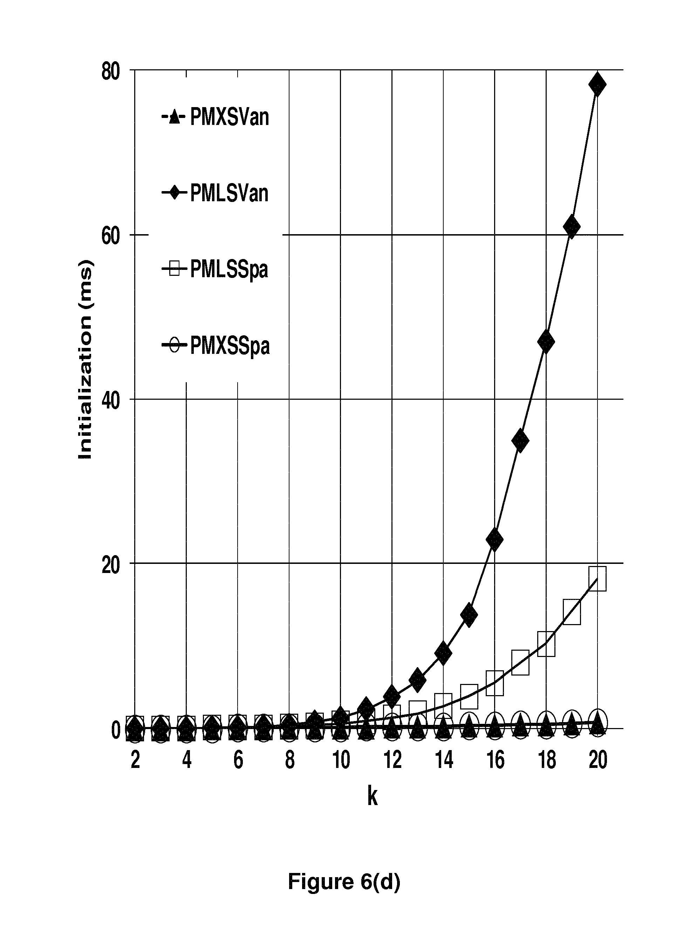

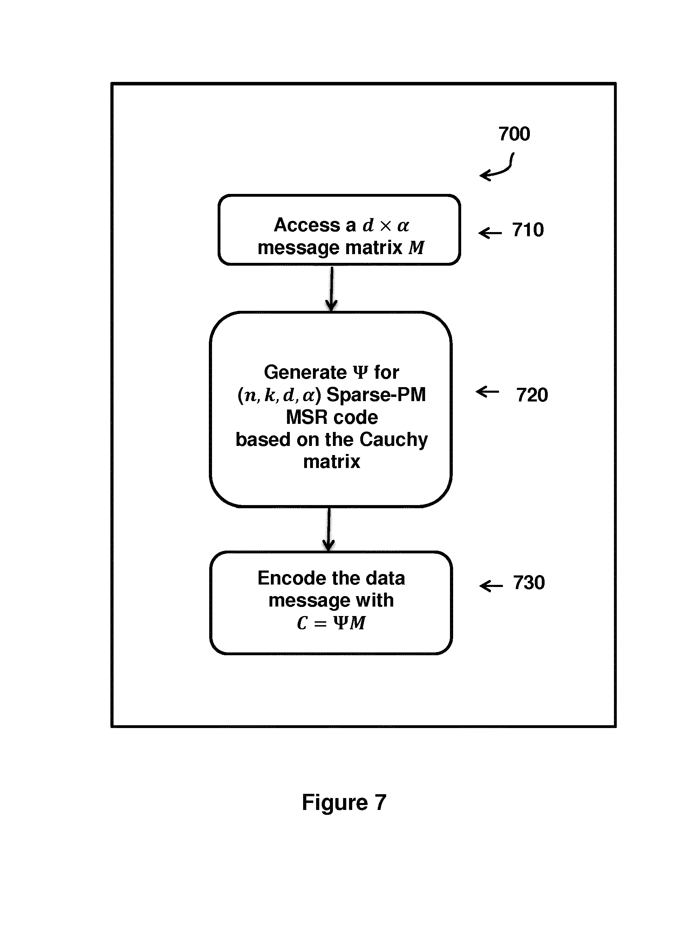

Figure 6 shows the performance of decoding (averaged over many failure patterns with 1 to $n - k$ failures) using data from systematic devices if available. The initialization cost does not include the generation of the generator matrix, which correspond to the initialization of the encoding operation and can be pre-computed once for all. The sparse PM code are faster than the vanilla PM codes. Using the linearized version of sparse PM codes is more interesting for low values of $k$ ($k < 12$ for non-systematic codes, $k < 21$ for systematic codes), and for large data (due to the initialization cost). Notice that the decoding method is independent of the encoding method. Therefore, it is possible to encode using the linear algorithm and to decode using the specific algorithm of the seminal paper. Figure 7 shows a flowchart 700 of a method of encoding data for fault-tolerance in a distributed storage system according to the present principles. The distributed storage system contains a plurality of storage nodes or devices connected in a network. The method includes the steps of: accessing 710 a message matrix M of dimension d $X$ $\alpha$ comprising $k \times \alpha$ symbols to be distributed over $k$ nodes; generating 720 a sparse-PM encoding matrix $\Psi$ for a ($n, k, d, \alpha$) MSR sparse-PM regenerating code based on the Cauchy matrix; and encoding 730 the data message according to the message matrix $\boldsymbol{M}$ and the sparse-PM encoding matrix of the sparse-PM regenerating code, wherein the encoded data is $\boldsymbol{C}$ = $\Psi M$ and is distributed over $n$ nodes. The message matrix $\boldsymbol{M}$ may generate a systematic regenerating code.

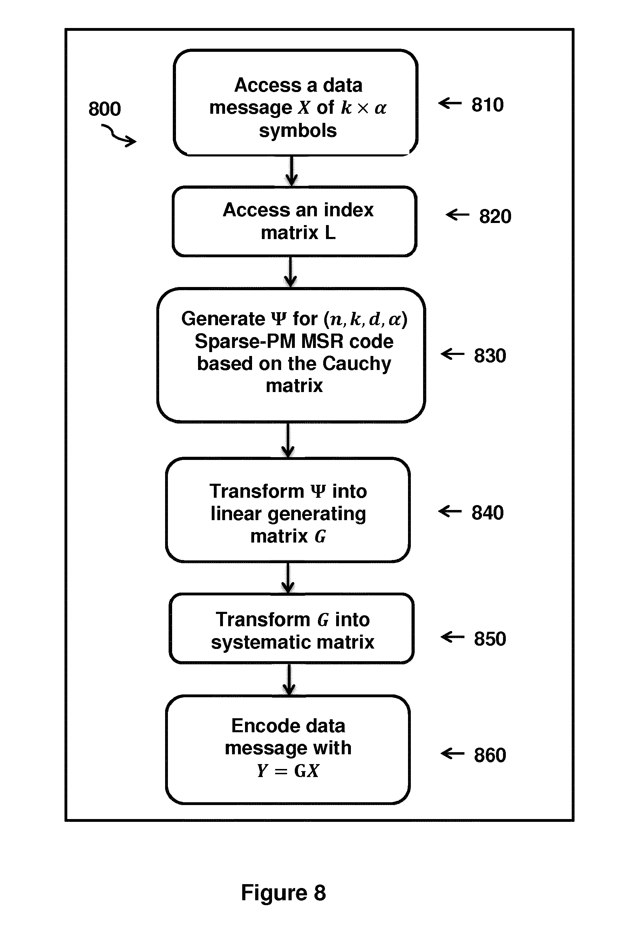

Figure 8 shows a flowchart of yet another method of encoding data for fault-tolerance in a distributed storage system according to the present principles. The distributed storage system contains a plurality of storage nodes or devices connected in a network. The method includes the steps of: accessing 810 a data message $\boldsymbol{X}$ comprising $k \times \alpha$ symbols to be distributed over $k$ nodes; accessing 820 an index matrix $L$ of dimension $2\alpha \times \alpha$; generating 830 a sparse-PM encoding matrix $\Psi$ for a ($n, k, d, \alpha$) MSR sparse-PM regenerating code based on the Cauchy matrix; transforming 840 the encoding matrix $\Psi$ into a sparse-PM linear generator matrix $G$; and encoding 860 the message data according to the sparse-PM generator matrix $\boldsymbol{G}$ of the regenerating code, wherein the encoded data is $\boldsymbol{Y}$ = G$X$ and is distributed over $n$ nodes. The method may also include the step of transforming 850 the sparse-PM generator matrix $\boldsymbol{G}$ into a systematic matrix prior to encoding the data message.

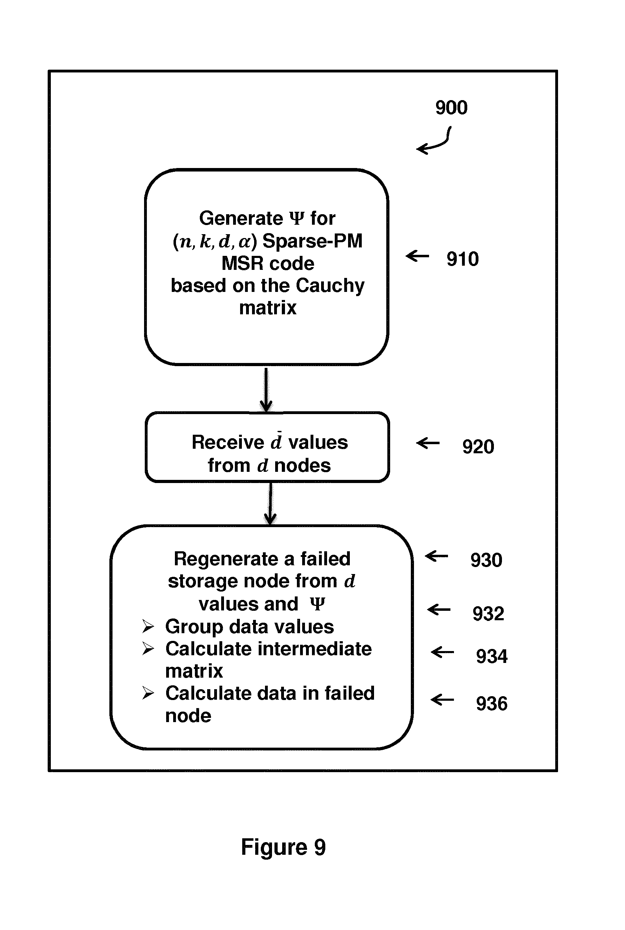

Figure 9 shows a flowchart 900 of a method of regenerating or repairing data for fault-tolerance in a distributed storage system according to the present principles. The distributed storage system contains a plurality of storage nodes or devices connected in a network. The method includes the steps of: generating 910 a sparse-PM encoding matrix $\Psi$ for a ($n, k, d, \alpha$) MSR sparse-PM regenerating code based on the Cauchy matrix; receiving 920 at least d data values from at least $\boldsymbol{d}$ nodes; regenerating 930 a failed storage node in the distributed storage system based on the data values and the sparse-PM encoding matrix $\Psi$. The data may have been encoded using an equivalent linear systematic code derived from said sparse-PM regenerating code. The regenerating step may further include the steps of: grouping 932 the data values into a data vector $V_{R1}$; calculating 934 an intermediate matrix $V_{R2}$ from the data vector; and calculating 936 the data stored in the failed storage node from the intermediate matrix, wherein the data comprises $\alpha$ symbols.

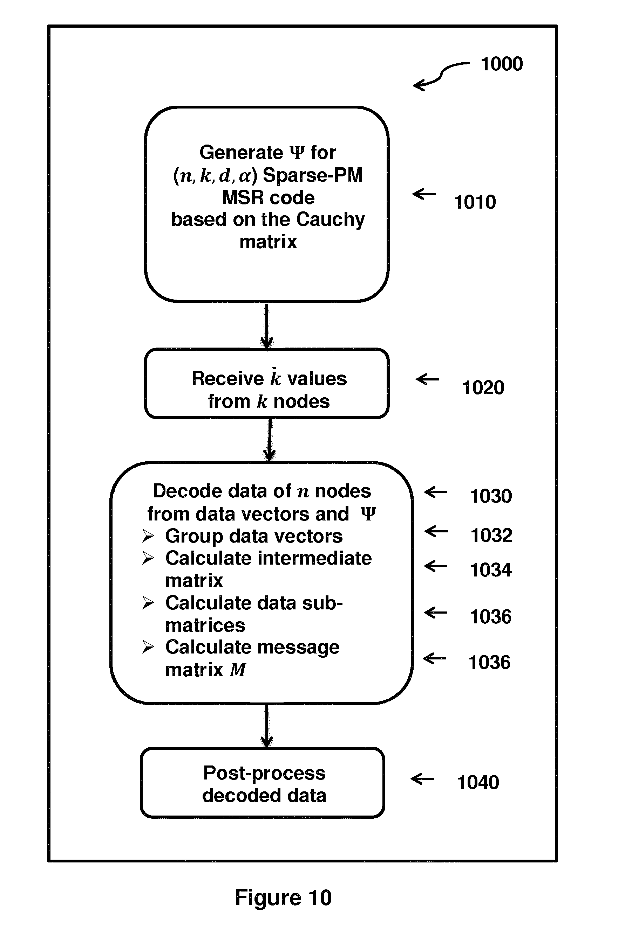

Figure 10 shows a flowchart 1000 of a method of decoding data for fault-tolerance in a distributed storage system according to the present principles. The distributed storage system contains a plurality of storage nodes or devices connected in a network. The method includes the steps of: generating 1010 a sparse-PM encoding matrix $\Psi$ for a ($n, k, d, \alpha$) MSR sparse-PM regenerating code based on the Cauchy matrix; receiving 1020 at least $k$ data vectors from at least $k$ nodes; decoding 1030 the data of the $n$ storage nodes in the distributed storage system based on the data vectors and the sparse-PM encoding matrix $\Psi$. The code may be a systematic sparse-PM regenerating code. The regenerating step may further include the steps of: grouping 1032 the data vectors into a data matrix $V_{D1}$; calculating 1034 an intermediate matrix $V_{D2}$ from the data vector, wherein $V_{D2}$ comprises data sub-matrices $\boldsymbol{P}$ and Q; calculating 1036 the symbols of data sub-matrices P and $\boldsymbol{Q}$ from the intermediate matrix; and calculating 1038 a message matrix $\boldsymbol{M}$ of the distributed storage system from the data sub-matrices and the sparse-PM encoding matrix $\Psi$. The method may further include the step of post-processing 1040 the decoded data to recover an original data, by applying the inverse of a systematic transformation, wherein the original data was preprocessed by the systematic transformation prior to encoding.

It is to be understood that the present principles may be implemented in various forms of hardware, software, firmware, special purpose processors, or a combination thereof. Preferably, the present principles are implemented as a combination of hardware and software. Moreover, the software is preferably implemented as an application program tangibly embodied on a program storage device. The application program may be uploaded to, and executed by, a machine comprising any suitable architecture. Preferably, the machine is implemented on a computer platform having hardware such as one or more central processing units (CPU), a random access memory (RAM), and input/output (I/O) interface(s). The computer platform also includes an operating system and microinstruction code. The various processes and functions described herein may either be part of the microinstruction code or part of the application program (or a combination thereof), which is executed via the operating system. In addition, various other peripheral devices may be connected to the computer platform such as an additional data storage device and a printing device.

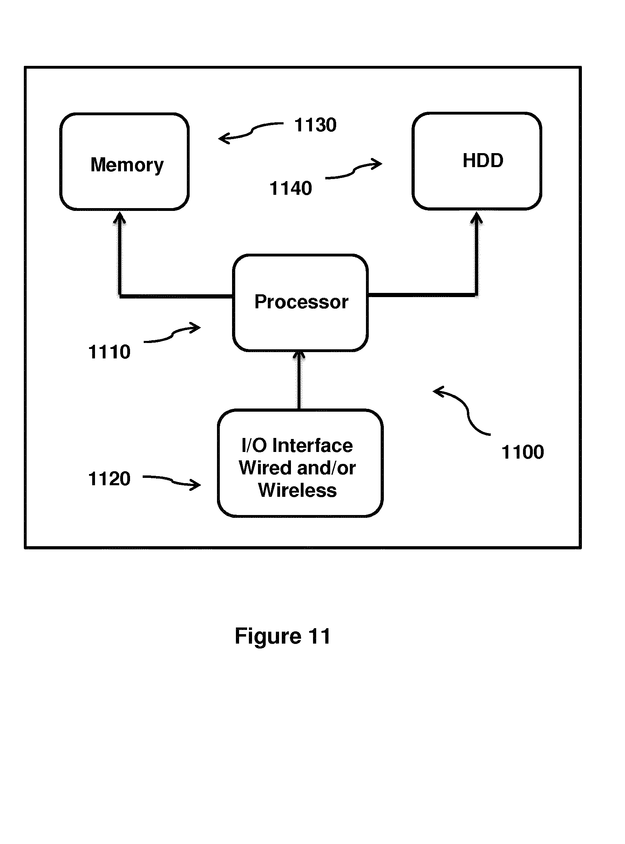

Figure 11 shows a block diagram of a minimum computing environment 1100 within which the present principles can be implemented and executed. The computing environment 1100 includes a processor 1102, and at least one (and preferably more than one) I/O interface 1104. The I/O interface can be wired or wireless and, in the wireless implementation is preconfigured with the appropriate wireless communication protocols to allow the computing environment 1100 to operate on a global network (e.g., internet) and communicate with other computers or servers (e.g., cloud based computing or storage servers) so as to enable the present principles to be provided, for example, as a Software as a Service (SAAS) feature remotely provided to end users. One or more memories 1106 and/or storage devices (HDD) 1108 are also provided within the computing environment 1100. The computing environment may be used to implement a node or device, and/or a controller or server who operates the storage system.

It is to be further understood that, because some of the constituent system components and methods depicted in the accompanying drawings are preferably implemented in software, the actual connections between the system components or the process function blocks may differ depending upon the manner in which the present principles are programmed. Given the teachings herein, one of ordinary skill in the pertinent art will be able to contemplate these and similar implementations or configurations of the present principles.

Although the illustrative embodiments have been described herein with reference to the accompanying drawings, it is to be understood that the present principles is not limited to those precise embodiments, and that various changes and modifications may be effected therein by one of ordinary skill in the pertinent art without departing from the scope of the present principles. All such changes and modifications are intended to be included within the scope of the present principles as set forth in the appended claims.

**Claims**

1.  A method of encoding data for fault-tolerance in a distributed storage system, said distributed storage system comprising a plurality of storage nodes, said method comprising:

    accessing (510) a message matrix $M$ of dimension d $\times$ $\alpha$ comprising a data message, wherein said data message comprises $k \times \alpha$ symbols to be distributed over $k$ nodes;
    generating (520) a sparse-PM encoding matrix for a ($n, k, d, \alpha$) MSR sparse-PM regenerating code based on the Cauchy matrix; and
    encoding (530) the data message according to said message matrix $M$ and said sparse-PM encoding matrix of said sparse-PM regenerating code, wherein the encoded data is $C = \Psi M$ and is distributed over $n$ nodes.

2.  The method of claim 1, wherein said sparse-PM encoding matrix comprises:

    $\Phi$ = [$\Phi$ $\Lambda\Phi$, $\Psi$ is a $n \times$ d matrix, $\Phi$ is a $n$ X $\alpha$ matrix and $\Lambda$ is a $n \times n$ diagonal matrix,

$$\Phi_{i,j} = \begin{cases} 0, \text{ for all } i \neq j, i \leq \alpha \\ 1, \text{ for all } i = j, i \leq \alpha \\ \dfrac{1}{a_i - b_j} \text{ , otherwise} \end{cases}$$

$$\Lambda_{i,j} = \begin{cases} 0, \text{ for all } i \neq j \\ \dfrac{a_i - b_1}{a_i - b_{\alpha+1}} \text{ , otherwise} \end{cases}$$

$$a_i = g^{i+\alpha};$$

$$b_j = g^{j-1};$$

and

*g* is a generator element of a finite field.

**3.** The method of claim 1 or 2, wherein said code is a systematic regenerating code.

**4.** A method of encoding data for fault-tolerance in a distributed storage system, said distributed storage system comprising a plurality of storage nodes, said method comprising:

accessing (610) a data message **X** comprising $k \times \alpha$ symbols to be distributed over *k* nodes;
accessing (620) an index matrix *L* of dimension $2\alpha \times \alpha$;
generating (630) a sparse-PM encoding matrix for a (*n, k, d, α*) MSR sparse-PM regenerating code based on the Cauchy matrix;
transforming (640) said encoding matrix Ψ (640) into a sparse-PM linear generator matrix *G*; and
encoding (660) the data message according to said sparse-PM linear generator matrix **G** of said regenerating code, wherein the encoded data is *Y* = G*X* and is distributed over *n* nodes.

**5.** The method of claim 4, wherein said sparse-PM linear generator matrix G comprises:

$$G_{\alpha i+j,l'} = \begin{cases} \Psi_{i,l}, \text{ if there exists } l \text{ such that } l' = L_{l,j} \\ 0, \text{ otherwise} \end{cases}$$

wherein *L* is an index matrix of dimension $2\alpha \times \alpha$.

**6.** An apparatus for encoding data for fault-tolerance in a distributed storage system, said distributed storage system comprising a plurality of storage nodes, said apparatus comprising a processor, for receiving at least one input/output; and at least one memory in signal communication with said processor, said processor being configured to:

access a message matrix **M** of dimension $d \times \alpha$ comprising a data message, wherein said data message comprises $k \times \alpha$ symbols to be distributed over *k* nodes;
generate a sparse-PM encoding matrix Ψ for a (*n, k, d, α*) MSR sparse-PM regenerating code based on the Cauchy matrix; and
encode the data message according to said message matrix **M** and said sparse-PM encoding matrix Ψ of said sparse-PM regenerating code, wherein the encoded data is **C** = Ψ*M* and is distributed over *n* nodes.

**7.** An apparatus of encoding data for fault-tolerance in a distributed storage system, said distributed storage system comprising a plurality of storage nodes, said apparatus comprising a processor, for receiving at least one input/output; and at least one memory in signal communication with said processor, said processor being configured to:

access a data message *X* comprising $k \times \alpha$ symbols to be distributed over *k* nodes;
access an index matrix *L* of dimension $2\alpha \times \alpha$;
generate a sparse-PM encoding matrix Ψ for a (*n, k, d, α*) MSR sparse-PM regenerating code based on the Cauchy matrix;
transform said encoding matrix Ψ (640) into a sparse-PM linear generator matrix *G*; and
encode the data message according to said sparse-PM linear generator matrix **G** of said regenerating code, wherein the encoded data is **Y** = G*X* and is distributed over *n* nodes.

**8.** The apparatus of claim 7, wherein said sparse-PM linear generator matrix **G** comprises:

$$G_{\alpha i+j,l'} = \begin{cases} \Psi_{i,l}, \text{ if there exists } l \text{ such that } l' = L_{l,j} \\ 0, \text{ otherwise} \end{cases}$$

wherein $L$ is an index matrix of dimension $2\alpha \times \alpha$.

9. A method of regenerating data for fault-tolerance in a distributed storage system, said distributed storage system comprising $n$ storage nodes, said method comprising:

generating (710) a sparse-PM encoding matrix for a ($n, k, d, \alpha$) MSR sparse-PM regenerating code based on the Cauchy matrix;
receiving (720) at least $d$ data values from at least $d$ nodes;
regenerating (730) a failed storage node in said distributed storage system based on said data values and said sparse-PM encoding matrix $\Psi$.

10. An apparatus for regenerating data for fault-tolerance in a distributed storage system, said distributed storage system comprising $n$ storage nodes, said apparatus comprising a processor, for receiving at least one input/output; and at least one memory in signal communication with said processor, said processor being configured to:

generate a sparse-PM encoding matrix $\Psi$ (520) for a ($n, k, d, \alpha$) MSR sparse-PM regenerating code based on the Cauchy matrix;
receive at least $d$ data values from at least $d$ nodes;
regenerate a failed storage node in said distributed storage system based on said data values and said sparse-PM encoding matrix $\Psi$.

11. A method of decoding data for fault-tolerance in a distributed storage system, said distributed storage system comprising $n$ storage nodes, said method comprising:

generating (810) a sparse-PM encoding matrix $\Psi$ for a ($n, k, d, \alpha$) MSR sparse-PM regenerating code based on the Cauchy matrix;
receiving (820) at least $k$ data vectors from at least $k$ nodes;
decoding (830) the data of the $n$ storage nodes in said distributed storage system based on said data vectors and said sparse-PM encoding matrix $\Psi$.

12. An apparatus for decoding data for fault-tolerance in a distributed storage system, said distributed storage system comprising $n$ storage nodes, said apparatus comprising a processor, for receiving at least one input/output; and at least one memory in signal communication with said processor, said processor being configured to:

generate a sparse-PM encoding matrix $\Psi$ (520) for a ($n, k, d, \alpha$) MSR sparse-PM regenerating code based on the Cauchy matrix;
receive at least $k$ data vectors from at least $k$ nodes;
decode the data of the $n$ storage nodes in said distributed storage system based on said data vectors and said sparse-PM encoding matrix $\Psi$.

13. A computer readable memory comprising an MSR Product-Matrix regenerating code for providing fault-tolerance in a distributed storage system, said code comprising a sparse-PM encoding matrix based on the Cauchy matrix.

14. A computer readable memory comprising a code for providing fault-tolerance in a distributed storage system, said code comprising a linear generator matrix **G characterized by**:

$$G_{\alpha i+j,l'} = \begin{cases} \Psi_{i,l}, \text{ if there exists } l \text{ such that } l' = L_{l,j} \\ 0, \text{ otherwise} \end{cases}$$

wherein $L$ is an index matrix of dimension $2\alpha \times \alpha$ and $\Psi$ is an encoding matrix of a sparse-PM regenerating code based on the Cauchy matrix.

15. A computer readable memory comprising a code for providing fault-tolerance in a distributed storage system, said code comprising a systematic generator matrix *G'*, wherein **G'** is a systematic transformation of a linear generator matrix **G characterized by**:

$$G_{\alpha i+j,l'} = \begin{cases} \Psi_{i,l}, & \text{if there exists } l \text{ such that } l' = L_{l,j} \\ 0, & \text{otherwise} \end{cases}$$

wherein $L$ is an index matrix of dimension $2\alpha \times \alpha$ and $\Psi$ is an encoding matrix of a sparse-PM regenerating code based on the Cauchy matrix.

Figure 1

Figure 2(a)

**Figure 2(b)**

Figure 2(c)

Figure 2(d)

Figure 3(a)

Figure 3(b)

**Figure 4(a)**

Figure 4(b)

Figure 5(a)

**Figure 5(b)**

Figure 6(a)

Figure 6(b)

Figure 6(c)

Figure 6(d)

700

Access a $d \times \alpha$
message matrix $M$ ← 710

Generate $\Psi$ for
$(n, k, d, \alpha)$ Sparse-PM
MSR code
based on the Cauchy
matrix ← 720

Encode the data
message with
$C = \Psi M$ ← 730

Figure 7

800

**810** Access a data message $X$ of $k \times \alpha$ symbols

**820** Access an index matrix L

**830** Generate $\Psi$ for $(n, k, d, \alpha)$ Sparse-PM MSR code based on the Cauchy matrix

**840** Transform $\Psi$ into linear generating matrix $G$

**850** Transform $G$ into systematic matrix

**860** Encode data message with $Y = GX$

Figure 8

900

### Generate $\Psi$ for $(n, k, d, \alpha)$ Sparse-PM MSR code based on the Cauchy matrix

← 910

### Receive $\bar{d}$ values from $d$ nodes

← 920

### Regenerate a failed storage node from $d$ values and $\Psi$

← 930

➢ Group data values

← 932

➢ Calculate intermediate matrix

← 934

➢ Calculate data in failed node

← 936

**Figure 9**

1000

Generate Ψ for
$(n, k, d, \alpha)$ Sparse-PM
MSR code
based on the Cauchy
matrix

← 1010

Receive $k$ values
from $k$ nodes

← 1020

Decode data of $n$ nodes
from data vectors and Ψ
➢ Group data vectors
➢ Calculate intermediate
  matrix
➢ Calculate data sub-
  matrices
➢ Calculate message
  matrix $M$

← 1030
← 1032
← 1034
← 1036
← 1036

Post-process
decoded data

← 1040

Figure 10

Figure 11

Europäisches
Patentamt
European
Patent Office
Office européen
des brevets

# EUROPEAN SEARCH REPORT

Application Number

EP 15 30 5185

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | Nicolas Le Scouarnec: "Fast Product-Matrix Regenerating Codes", , 9 December 2014 (2014-12-09), XP002742075, Retrieved from the Internet: URL:http://arxiv.org/pdf/1412.3022v1.pdf [retrieved on 2015-07-10] | 1-8, 13-15 | INV. H03M13/13 H03M13/37 G06F11/10 |
| Y | * abstract * * page 1 - page 4 * | 9-12 | |
| Y,D | RASHMI K V ET AL: "Optimal Exact-Regenerating Codes for Distributed Storage at the MSR and MBR Points via a Product-Matrix Construction", IEEE TRANSACTIONS ON INFORMATION THEORY, IEEE PRESS, USA, vol. 57, no. 8, 1 August 2011 (2011-08-01) , pages 5227-5239, XP002669405, ISSN: 0018-9448, DOI: 10.1109/TIT.2011.2159049 | 9-12 | |
| A | * page 5233 * | 1-8, 13-15 | TECHNICAL FIELDS SEARCHED (IPC) H03M G06F H04L |

The present search report has been drawn up for all claims

| Place of search | Date of completion of the search | Examiner |
|---|---|---|
| Munich | 15 July 2015 | Burkert, Frank |

EPO FORM 1503 03.82 (P04C01)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 14306444 A

**Non-patent literature cited in the description**

- **A.G. DIMAKIS et al.** Network Coding for Distributed Storage Systems. *IEEE Transactions on Information Theory,* September 2010, vol. 56, 4539-4551

- **R.V. RASHMI et al.** Optimal Exact-Regenerating Codes for Distributed Storage at the MSR and MBR Points via a Product-Matrix Construction. *IEEE Transactions on Information Theory,* 2011, vol. 57, 5227-5239